# EUROPEAN PATENT APPLICATION

(11) **EP 1 571 469 A1**
(43) Date of publication of application: **07.09.2005**
(21) Application number: 03813718.8
(22) Date of filing: 28.11.2003
(51) Int. Cl.: G02B 5/20, G03F 7/004, G03F 7/027, G03F 7/032

(54) **COLORED PHOTOSENSITIVE COMPOSITION FOR COLOR FILTERS, COLOR FILTERS, AND PROCESS FOR THE PRODUCTION THEREOF**

(30) Priority: 29.11.2002 JP 2002349305
(71) Applicant: DAICEL CHEMICAL INDUSTRIES, LTD., Osaka 590-0905 (JP)
(72) Inventor: OKAZAKI, Akira, Otake-shi, Hiroshima 739-0651 (JP); MIYAKE, Hiroto, Otake-shi, Hiroshima 739-0651 (JP)
(86) International application number: PCT/JP2003/015293
(87) International publication number: WO 2004/057380

(57) **Abstract**

The present invention relates to: a colored photosensitive composition for a color filter; a color filter obtained by curing the colored photosensitive composition; and a method of producing a color filter. The colored photosensitive composition is **characterized by** including: a polyether compound represented by the following formula (4), 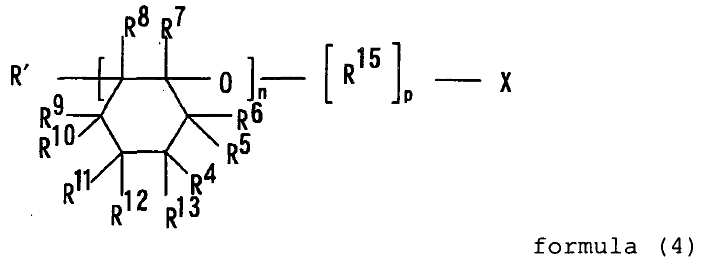 having multiple polymerizable unsaturated groups and one or more acid groups in one molecule; a coloring matter; and a curable resin and/or an ethylenically unsaturated compound to be optionally added.

In the formula (4), R' represents a residue -RHₘ₋₁ of an organic compound RHₘ containing "m" pieces of active hydrogen atoms in one molecule, or a group derived from the residue; R represents a residue obtained by removing an active hydrogen atom from an organic compound having the active hydrogen atom; "m" represents an integer of 1 to 30; R⁴ to R¹³ each represent a hydrogen atom, a hydrocarbon group having 1 to 10 carbon atoms, or a hydrocarbon group having 1 to 10 carbon atoms and an unsaturated group, provided that the unsaturated group contains -OCO-CR³=CR¹R², R¹ and R² each represent a hydrogen atom, R³ represents a hydrogen atom or a hydrocarbon group having 1 to 10 carbon atoms, and at least one of R⁴ to R¹³ represents a hydrocarbon group having 1 to 10 carbon atoms and the unsaturated group; R¹⁵ represents a residue of a polybasic acid anhydride; X represents -COOH, -OPO(OH)ₐ(OR)_{b}, or -OSO₃R (provided that R represents a hydrogen atom, a methyl group, or an ethyl group, "a" represents 1 or 0, and "a+b" = 2); "n" represents an integer of 1 or more, and the number of structural units in the entire molecule represented by n is in the range of 2 to 50; and "p" represents 0 when X represents -OPO(OH)ₐ(OR)_{b} or -OSO₃R, while "p" represents an integer of 1 or more when X represents -COOH. The method of producing a color filter is **characterized by** including the steps of: applying the colored photosensitive composition onto a substrate; subjecting the colored photosensitive composition applied onto the substrate to pattern exposure to photo-cure the colored photosensitive composition in an exposed portion; and developing the colored photosensitive composition subjected to the pattern exposure to leave a pattern-like colored layer obtained by photo-curing the colored photosensitive composition on the substrate. As a result, a colored photosensitive composition for a color filter having high developability and high photosensitivity with a diluted alkali and suitable for image-forming applications such as a pigment-dispersed resist, a color filter obtained by curing the composition, and a color filter are obtained.

## Description

### TECHNICAL FIELD

The present invention relates to a colored photosensitive composition useful for producing a color filter, a black matrix, a photospacer for a liquid crystal, a TFT array, or the like used in a color liquid crystal display, a color video camera, an image scanner, or the like. More specifically, the present invention relates to a colored photosensitive liquid composition for a color filter which contains a coloring matter such as a pigment or a dye so as to be capable of forming an image through exposure to ultraviolet rays and development with a dilute alkaline aqueous solution after the formation of a coating film, and which is excellent in ultraviolet rays curability, compatibility, and developability. The present invention also relates to: a color filter using the colored photosensitive composition for a color filter; and a method of producing a color filter.

### BACKGROUND ART

In recent years, liquid crystal display devices and the like have shown a tendency of upsizing, so color filters to be used for such devices must be thin with no defects, and, furthermore, must have high transparency and high contrast. In addition, a reduction in production cost for a color filter has been demanded, so an increase in yield and a reduction in number of production steps are required. A color filter is obtained by arranging pixels of three primary colors on a transparent substrate made of glass or the like in a triangle fashion, in a mosaic fashion, or in a stripe fashion. A pixel of a color filter for a charge-coupled device (CCD) is of a fine shape having a width in the range of 5 or 6 µm to 20 or 30 µm. In addition, pixels of a color filter for a liquid crystal display device (LCD) each have a width in the range of 20 or 30 µm to about 200 µm, and they must be arranged systematically in a predetermined order for each hue.

A method has been conventionally employed as a method of producing a color filter, which involves: applying, to a glass substrate, a colored photosensitive composition obtained by dispersing a coloring matter such as a pigment into a photosensitive composition allowing development with an organic solvent or an alkaline aqueous solution; drying the applied composition; exposing the dried composition to ultraviolet rays; forming a pattern through development; and repeating the above steps. An alkali development type composition has gone mainstream owing to the recent environmental problems.

An acrylic resin (see, for example, JP 02-144502 A) has been used for such a colored photosensitive composition because of its excellent weatherability and small color change. In addition, JP 03-53201 A discloses a colored photosensitive composition obtained by incorporating a pigment and a polyfunctional acrylate into an acrylic resin.

An epoxy (meth)acrylate resin obtained by subjecting an epoxy group of an epoxy resin to a ring-opening reaction with acrylic acid or methacrylic acid described in JP 06-157965 A can be used as an active energy ray-curable resin. However, such an epoxy (meth) acrylate resin has disadvantages of being hard, being brittle, having no flexibility, and contracting to a large extent at the time of curing. A colored photosensitive composition using such a resin is excellent in weatherability, but the epoxy (meth)acrylate itself serving as a binder is not involved in curing, so sufficient resolution cannot be obtained. In addition, physical properties of a coating film after the curing, especially alkali resistance, solvent resistance, and humidity resistance are insufficient. JP 06-230212 A discloses a colored photosensitive composition composed of: a photosensitive compound in which a double bond is introduced into side chains of an acrylic resin having a hydroxyl group through isocyanate; and a pigment. In such a composition, the acrylic resin itself serving as a binder also cures, so a cured coating film excellent in alkali resistance and solvent resistance can be obtained. However, a colored photosensitive composition using such an acrylic resin has insufficient sensitivity and insufficient resolution, and keeps its tackiness even after the removal of a solvent, with the result that a photomask is often contaminated at the stage of exposure. In addition, a reduction in amount of a diluent monomer or a diluent oligomer to be added for suppressing the tackiness results in a problem in that neither sufficient photosensitivity nor sufficient resolution is obtained. Furthermore, JP 08-262221 A discloses a colored photosensitive composition for a color filter containing an unsaturated group-containing acrylic resin as an essential ingredient, but the composition is not always sufficient in terms of developability and photosensitivity of a coating film to be cured.

### DISCLOSURE OF THE INVENTION

In view of the above circumstances, the inventors of the present invention have made extensive studies to solve the problems of the prior arts. As a result, they have found that a colored photosensitive composition for a color filter of the present invention containing as essential ingredients: a polyether compound containing multiple special unsaturated groups, an acid group, and the like; and a coloring matter has high developability and high photosensitivity. They have also found that a color filter obtained by curing the colored photosensitive composition can solve the above problems. Thus, they have completed the present invention.

That is, a first invention provides a colored photosensitive composition for a color filter, characterized by including: a polyether compound represented by the following formula (4) having multiple polymerizable unsaturated groups and one or more acid groups in one molecule; a coloringmatter; and a curable resin and/or an ethylenically unsaturated compound to be optionally added, 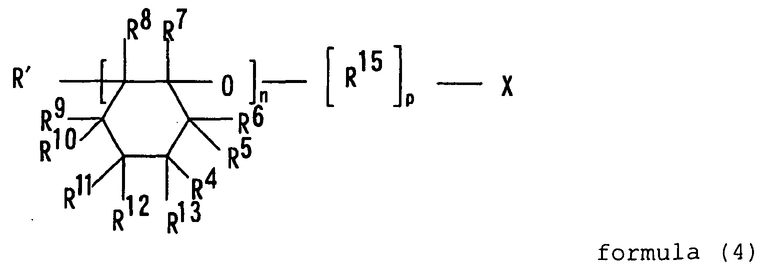 [In the formula (4), R' represents a residue -RHₘ₋₁ of an organic compound RHₘ containing "m" pieces of active hydrogen atoms in one molecule, or a group derived from the residue; R represents a residue obtained by removing an active hydrogen atom from an organic compound having the active hydrogen atom; "m" represents an integer of 1 to 30; R⁴ to R¹³ each represent a hydrogen atom, a hydrocarbon group having 1 to 10 carbon atoms, or a hydrocarbon group having 1 to 10 carbon atoms and an unsaturated group, provided that the unsaturated group contains -OCO-CR³=CR¹R², R¹ and R² each represent a hydrogen atom, R³ represents a hydrogen atom or a hydrocarbon group having 1 to 10 carbon atoms, and at least one of R⁴ to R¹³ represents a hydrocarbon group having 1 to 10 carbon atoms and the unsaturated group; R¹⁵ represents a residue of a polybasic acid anhydride; X represents -COOH, -OPO(OH)ₐ(OR)_{b}, or -OSO₃R (provided that R represents a hydrogen atom, a methyl group, or an ethyl group, "a" represents 1 or 0, and "a+b" = 2) ; "n" represents an integer of 1 or more, and the number of structural units in the entire molecule represented by "n" is in the range of 2 to 50; and "p" represents 0 when X represents -OPO(OH)ₐ(OR)_{b} or -OSO₃R, while "p" represents an integer of 1 or more when X represents -COOH].

A second invention provides a colored photosensitive composition for a color filter according to the first invention, in which the polyether compound is one represented by the following formula (4A) having multiple (meth) acryloyl groups and one or more carboxyl groups in one molecule, 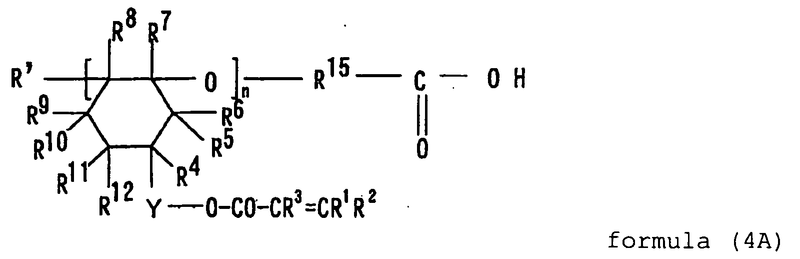 [In the formula (4A), R' represents a residue -RHₘ₋₁ of an organic compound RHₘ containing m or more active hydrogen atoms in one molecule, or a group derived from the residue; R represents a residue obtained by removing an active hydrogen atom from an organic compound having the active hydrogen atom; "m" represents an integer of 1 to 30; R⁴ to R¹² each represent a hydrogen atom or a hydrocarbon group having 1 to 10 carbon atoms; R¹ and R² of -OCO-CR³=CR¹R² each represent a hydrogen atom, and R³ of -OCO-CR³=CR¹R² represents a hydrogen atom or a methyl group; Y represents -(CH₂)ₙ₁- where n1 represents an integer of 1 to 6, one obtained by substituting part of the hydrogen atoms constituting -(CH₂)ₙ₁- by methyl groups, ethyl groups, or propyl groups, or one of the following structural formulae, 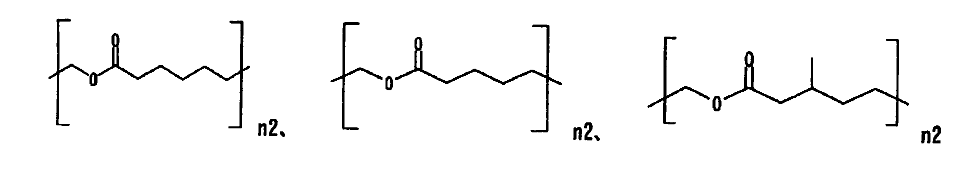 where n2 represents an integer of 1 to 10; R¹⁵ represents a residue produced by ring-opening of a polybasic acid anhydride; and "n" represents an integer of 1 or more, and the number of structural units in the entire molecule represented by n is in the range of 2 to 50].

A third invention provides a colored photosensitive composition for a color filter according to the first or second invention, in which the polybasic acid anhydride is at least one selected from the group consisting of tetrahydrophthalic anhydride, 4-methyltetrahydrophthalic anhydride, 3-methyltetrahydrophthalic anhydride, 3,4,5,6-tetrahydrophthalic anhydride, hexahydrophthalic anhydride, and 4-methyltetrahydrophthalic anhydride.

A fourth invention provides a colored photosensitive composition for a color filter according to the first invention, in which the polyether compound is a polyether compound represented by the following formula (4A') obtained by reacting a compound represented by the following formula (3A) with a polybasic acid anhydride, the compound represented by the following formula (3A) being obtained by reacting an organic compound RHₘ containing "m" pieces of active hydrogen atoms in one molecule which is at least one selected from the group consisting of carboxylic acids, alcohols, phenols, amines, thiols, and silanols, and in which "m" represents an integer of 1 to 30 (hereinafter, they are represented by R*Hₘ) with a compound represented by the following formula (2A), 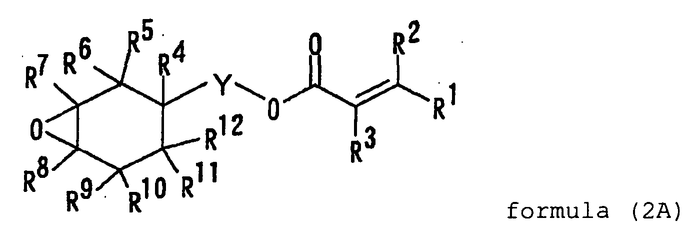 <In the formula (2A), R¹ and R² each represent a hydrogen atom; R³ represents a hydrogen atom or a methyl group; R⁴ to R¹² each represent a hydrogen atom, a methyl group, an ethyl group, or a propyl group; and Y represents -(CH₂)ₙ₁- where n1 represents an integer of 1 to 6, one obtained by substituting part of the hydrogen atoms constituting -(CH₂)ₙ₁- by methyl groups, ethyl groups, or propyl groups, or one of the following structural formulae, 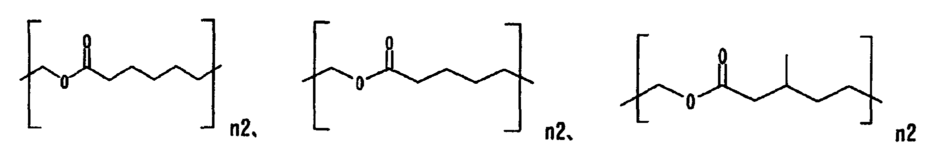 where n2 represents an integer of 1 to 10>, 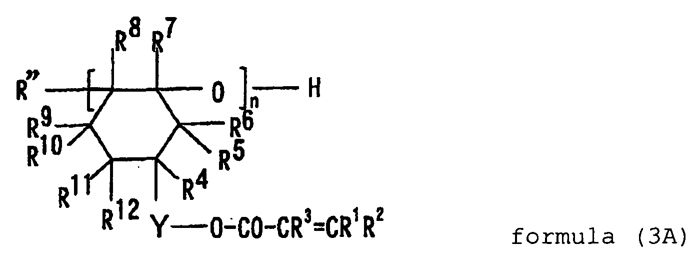 <In the formula (3A), R'' represents a residue -R*Hₘ₋₁ of carboxylic acids, alcohols, phenols, amines, thiols, or silanols, or a group derived from the residue; R¹ and R² each represent a hydrogen atom; R³ represents a hydrogen atom or a methyl group; R⁴ to R¹² each represent a hydrogen atom, a methyl group, an ethyl group, or a propyl group; Y is the same as that of the formula (2A) ; and "n" represents an integer of 2 to 50>, 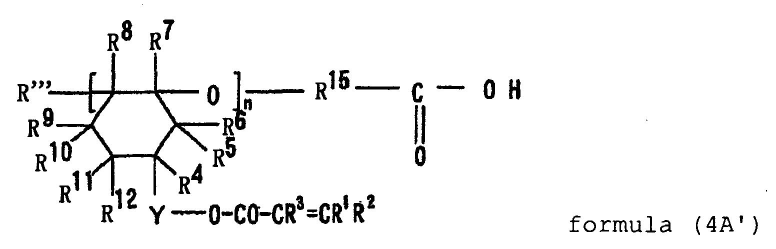 <In the formula (4A'), R¹⁵ represents a residue of a polybasic acid anhydride; and R''' represents a residue -R*Hₘ₋₁ or a group derived from the residue>.

A fifth invention provides a colored photosensitive composition for a color filter according to any one of the first to fourth inventions, in which the organic compound containing "m" pieces of active hydrogen atoms in one molecule is trimethylolpropane.

A sixth invention provides a colored photosensitive composition for a color filter according to the fourth or fifth invention, in which the compound represented by the formula (2A) is 3,4-epoxycyclohexylmethyl (meth)acrylate.

A seventh invention provides a colored photosensitive composition for a color filter according to the first invention, in which the curable resin is a resin obtained by reacting a (meth) acrylic acid-(meth)acrylate copolymer with a compound represented by the formula (2A), 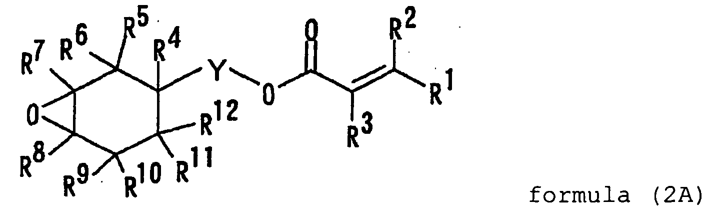 <In the formula (2A), R¹ and R² each represent a hydrogen atom; R³ represents a hydrogen atom or a methyl group; R⁴ to R¹² each represent a hydrogen atom, a methyl group, an ethyl group, or a propyl group; and Y represents -(CH₂)ₙ₁- where n1 represents an integer of 1 to 6, one obtained by substituting part of the hydrogen atoms constituting -(CH₂)ₙ₁- by methyl groups, ethyl groups, or propyl groups, or one of the following structural formulae, 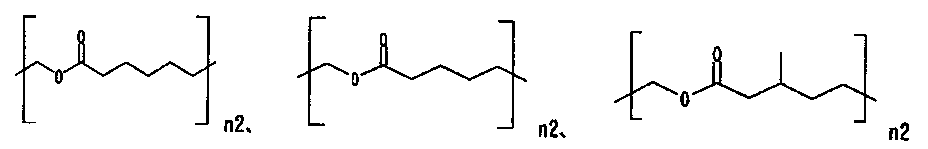 where n2 represents an integer of 1 to 10>.

An eighth invention provides a colored photosensitive composition for a color filter according to the first invention, in which the polyether compound is a polyether compound represented by the formula (4) obtained by reacting a compound represented by the following formula (3) with any one of a polybasic acid anhydride, phosphoric acid, ethyl phosphate, diethyl phosphate, a monoalkyl ester or dialkyl ester of glucose phosphate, sulfuric acid, methyl sulfate, and ethyl sulfate, the compound represented by the following formula (3) being obtained by reacting an organic compound RHₘ containing "m" pieces of active hydrogen atoms in one molecule (provided that "m" represents an integer of 1 to 30, and R represents a residue obtained by removing an active hydrogen atom from an organic compound having the active hydrogen atom) with a compound represented by the following formula (2), 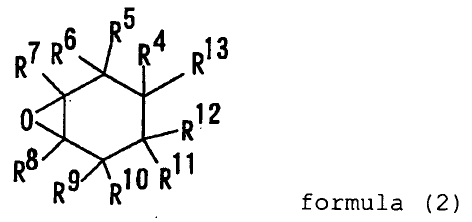 <R⁴ to R¹³ each represent a hydrogen atom, a hydrocarbon having 1 to 10 carbon atoms, or a hydrocarbon group having 1 to 10 carbon atoms and an unsaturated group, provided that the unsaturated group contains -OCO-CR³=CR¹R², at least one of R⁴ to R¹³ represents the unsaturated group, R¹ and R² each represent a hydrogen atom, and R³ represents a hydrogen atom or a hydrocarbon group having 1 to 10 carbon atoms>, 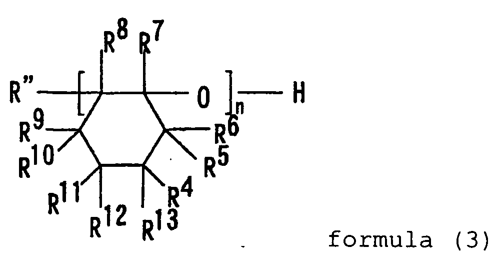 <In the formula (3), R'' represents a residue -RHₘ₋₁ of an organic compound containing "m" pieces of active hydrogen atoms in one molecule, or a group derived from the residue; R represents a residue obtained by removing an active hydrogen atom from an organic compound having the active hydrogen atom; and R⁴ to R¹³ each represent a hydrogen atom, a hydrocarbon having 1 to 10 carbon atoms, or a hydrocarbon group having 1 to 10 carbon atoms and an unsaturated group, provided that the unsaturated group contains -OCO-CR³=CR¹R², R¹ and R² each represent a hydrogen atom, and R³ represents a hydrogen atom or a hydrocarbon group having 1 to 10 carbon atoms>, 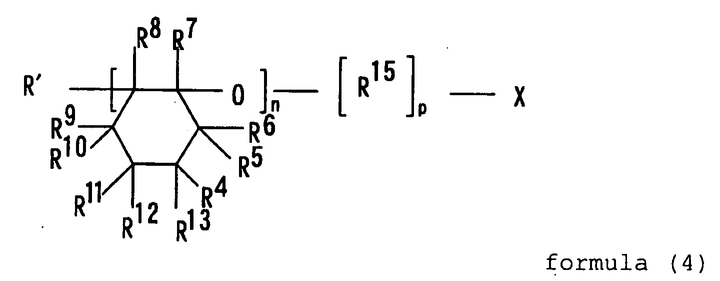 [In the formula (4), R' represents a residue -RHₘ₋₁ of an organic compound RHₘ containing "m" pieces of active hydrogen atoms in one molecule, or a group derived from the residue; R represents a residue obtained by removing an active hydrogen atom from an organic compound having the active hydrogen atom; "m" represents an integer of 1 to 30; R⁴ to R¹³ each represent a hydrogen atom, a hydrocarbon group having 1 to 10 carbon atoms, or a hydrocarbon group having 1 to 10 carbon atoms and an unsaturated group, provided that the unsaturated group contains -OCO-CR³=CR¹R², R¹ and R² each represent a hydrogen atom, R³ represents a hydrogen atom or a hydrocarbon group having 1 to 10 carbon atoms, and at least one of R⁴ to R¹³ represents a hydrocarbon group having 1 to 10 carbon atoms and the unsaturated group; R¹⁵ represents a residue of a polybasic acid anhydride; X represents -COOH, -OPO(OH)ₐ(OR)_{b}, or -OSO₃R (provided that R represents a hydrogen atom, a methyl group, or an ethyl group, "a" represents 1 or 0, and "a+b" = 2); "n" represents an integer of 1 or more, and the number of structural units in the entire molecule represented by "n" is in the range of 2 to 50; and "p" represents 0 when X represents -OPO(OH)ₐ(OR)_{b} or -OSO₃R, while "p" represents an integer of 1 or more when X represents -COOH].

A ninth invention provides a colored photosensitive composition for a color filter according to the first invention, in which the curable resin and/or the ethylenically unsaturated compound to be optionally added are an epoxy group-containing resin and/or an acid group-containing resin.

A tenth invention provides a colored photosensitive composition for a color filter according to any one of the first to ninth inventions, in which the polyether compound is a polyether compound synthesized by using a reactive diluent as a solvent.

An eleventh invention provides a colored photosensitive composition for a color filter according to any one of the first to ninth inventions, in which the polyether compound is a polyether compound synthesized by passing a mixed gas containing oxygen through a reaction system.

Atwelfth invention provides a color filter obtained by: applying the colored photosensitive composition for a color filter according to any one of the first to eleventh inventions; and curing the applied composition.

A thirteenth invention provides a method of producing a color filter, characterized by including the steps of: applying the colored photosensitive composition for a color filter according to any one of the first to eleventh inventions onto a substrate; subjecting the colored photosensitive composition applied onto the substrate to pattern exposure to photo-cure the colored photosensitive composition in an exposed portion; and developing the colored photosensitive composition subjected to the pattern exposure to leave a pattern-like colored layer obtained by photo-curing the colored photosensitive composition on the substrate.

### BRIEF DESCRIPTION OF THE DRAWINGS

Fig. 1 is an NMR chart of a polyether compound before addition of a dibasic acid anhydride obtained in Synthesis Example 1 according to the present invention.
Fig. 2 is an NMR chart of a polyether compound of Synthesis Example 2 used in a colored photosensitive composition according to the present invention.
Fig. 3 is a sectional drawing showing an example of a liquid crystal display device using a color filter according to the present invention.

Description of reference numerals: 4 pixel electrode, 10 color filter, 11 transparent substrate

### BEST MODE FOR CARRYING OUT THE INVENTION

Hereinafter, the embodiments of the present invention will be described.

A description is given of a polyether compound represented by the formula (4) having multiple polymerizable unsaturated groups and one or more acid groups in one molecule, the compound being used as a main resin component in a colored photosensitive composition for a color filter of the present invention.

The polyether compound represented by the formula (4) can also be represented by the following formula (IV), 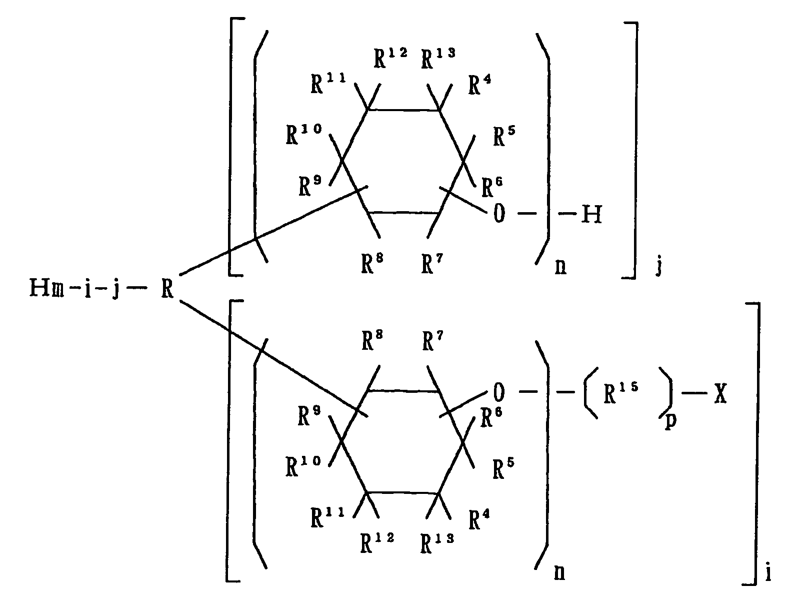 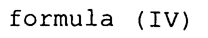 [In the formula (IV), R represents an m-valent residue obtained by removing an active hydrogen atom H from an organic compound RHₘ containing "m" pieces of active hydrogen atoms in one molecule; "m" represents an integer of 1 to 30; i and j each represent the number of substituents for R except H, provided that 1 ≤ i ≤ m, 0 ≤ j ≤ m, and 1 ≤ i + j ≤ m; R⁴ to R¹³ each represent a hydrogen atom, a hydrocarbon group having 1 to 10 carbon atoms, or a hydrocarbon group having 1 to 10 carbon atoms and an unsaturated group, provided that the unsaturated group contains -OCO-CR³=CR¹R², R¹ and R² each represent a hydrogen atom, R³ represents a hydrogen atom or a hydrocarbon group having 1 to 10 carbon atoms, and at least one of R⁴ to R¹³ represents a hydrocarbon group having 1 to 10 carbon atoms and the unsaturated group; R¹⁵ represents a residue of a polybasic acid anhydride; X represents -COOH, -OPO (OH)ₐ(OR)_{b}, or -OSO₃R (provided that R represents a hydrogen atom, a methyl group, or an ethyl group, "a" represents 1 or 0, and "a+b" = 2); "n" in one substituent represents an integer of 1 or more, "n" in the respective substituents may be equal to or different from each other, and the sum of "n" in the entire molecule is in the range of 2 to 50; and "p" represents 0 when X represents -OPO(OH)ₐ(OR)_{b} or -OSO₃R, while "p" represents an integer of 1 or more when X represents -COOH].

An organic compound RHₘ containing one or more pieces of active hydrogen atoms in one molecule (provided that "m" represents an integer of 1 to 30, and R represents a residue obtained by removing an active hydrogen atom from an organic compound having the active hydrogen atom) is required as a raw material for a first-stage reaction in the synthesis of the polyether compound. Examples of such a compound include carboxylic acids, alcohols, phenols, amines, thiols, and silanols. Specific examples of carboxylic acids used at this time include formic acid, acetic acid, propionic acid, butanoic acid, aliphatic acids of animal and vegetable oils, phthalic acid, acrylic acid, methacrylic acid, maleic acid, fumaric acid, itaconic acid, succinic acid, adipic acid, azelaic acid, phthalic acid, isophthalic acid, terephthalic acid, hexahydrophthalic acid, methylhexahydrophthalic acid, tetrahydrophthalic acid, trimellitic acid, pyromellitic acid, biphenyl tetracarboxylic acid, diphenyl ether tetracarboxylic acid, diphenyl sulfone tetracarboxylic acid, tetracarboxybenzophenone, β-carboxyethyl (meth)acrylate, 2-(meth)acryloyloxyethyl succinic acid, 2-(meth)acryloyloxyethyl hexahydrophthalic acid, 2-(meth)acryloyloxyethyl phthalic acid, 2-(meth)acryloyloxyethyl hydrogen phthalate, and 2-(meth)acryloyloxypropyl hydrogen phthalate.

It is to be noted that the term "(meth)acryl" refers to both "acryl" and "methacryl".

Specific examples of available alcohols include: aliphatic alcohols such as methanol, ethanol, propanol, butanol, hexanol, and octanol; aromatic alcohols such as benzyl alcohol; polyhydric alcohols such as ethylene glycol, diethylene glycol, triethylene glycol, polyethylene glycol, propylene glycol, dipropylene glycol, 1,3-propanediol, 1,3-butanediol, 1,4-butanediol, pentanediol, 1,6-hexanediol, neopentyl glycol, neopentyl glycol oxypyvalate, cyclohexanol, cyclohexanediol, cyclohexanedimethanol, glycerin, diglycerin, polyglycerin, trimethylolpropane, trimethylolethane, pentaerythritol, dipentaerythritol, hydrogenated bisphenol A, hydrogenated bisphenol F, and hydrogenated bisphenol S; and (meth)acrylate monomers each having a hydroxyl group such as 2-hydroxyethyl (meth)acrylate, hydroxypropyl (meth)acrylate, and hydroxybutyl (meth)acrylate.

Examples of the phenols include phenol, cresol, catechol, pyrogallol, hydroquinone, hydroquinone monomethyl ether, bisphenol, bisphenol A, bisphenol F, bisphenol S, 4,4-dihydroxybenzophenone, phenol resins, and cresol-novolac resins.

Examples of the amines include monomethylamine, dimethylamine, monoethylamine, diethylamine, monopropylamine, dipropylamine, monobutylamine, dibutylamine, benzylamine, hexylamine, cyclohexylamine, octylamine, dodecylamine, 4,4-diaminodiphenylmethane, isophoronediamine, toluenediamine, hexamethylenediamine, xylenediamine, diethylenetriamine, triethylenetetramine, and ethanolamine.

Examples of the thiols include methyl mercaptan, ethyl mercaptan, propyl mercaptan, and phenyl mercaptan. Examples of the other compounds each having one or more pieces of active hydrogen atoms include: silicone compounds each having a silanol group; polyvinyl alcohol; partially hydrolyzed products of polyvinyl acetate; starch; acryl polyol resins; styrene allyl alcohol copolymer resins; styrene-maleic acid copolymer resins; alkyd resins; polyester polyol resins; polyester carboxylic acid resins; polycaprolactone polyol resins; polypropylene polyol; polytetramethylene glycol; polycarbonate polyols; polybutadiene having a hydroxyl group; cellulose; and cellulose-based polymers such as cellulose acetate, cellulose acetate butyrate, and hydroxyethylcellulose.

Any of those compounds each having one or more pieces of active hydrogen atoms can be used, and two or more of them can be mixed. A polyether compound represented by the formula (3) can be formed by acting moisture in the raw material as an initiator without using any one of the above compounds each having one or more pieces of active hydrogen atoms.

A catalyst is preferably used at the time of a reaction between any one of the above organic compounds each having one or more active hydrogen atoms and the compound represented by the formula (2). Examples of the catalyst include: Lewis acids such as BF₃, ZnCl₂, AlCl₃, and SnCl₄; and complexes of those acids with ethers and the like. Furthermore, sulfonium-based, ionium-based, and other photocationic catalysts that generate acids through irradiation with rays can be used. Such a catalyst is used in an amount in the range of preferably 0.01 to 10% by weight, particularly preferably 0.1 to 5% by weight with respect to the reactant. An amount of the catalyst to be used of less than 0.1% by weight is not preferable because the reaction requires a long time period. An amount of the catalyst to be used in excess of 10% by weight is not preferable either because a side reaction is apt to occur, so the product may be stained or gelled. In the reaction between any one of the carboxylic acids, alcohols, phenols, amines, and thiols each having one or more active hydrogen atoms in one molecule and the compound represented by the formula (2), it is essential to use 2 to 50 chemical equivalents of the epoxy group of the compound represented by the formula (2) with respect to 1 chemical equivalent of a carboxyl group, a hydroxyl group, or the like. The amount of the epoxy group used is preferably 3 chemical equivalents or more, particularly preferably in the range of 5 to 30 chemical equivalents. An amount of less than 2 chemical equivalents is not preferable because the coating film hardness of a cured product formed of the resultant polyether compound as a curable composition reduces. An amount in excess of 50 chemical equivalents is not preferable either because the product is apt to be gelled and a liquid viscosity is so high that handling, sensitivity at the time of ultraviolet rays curing, and the like deteriorate. Furthermore, a reaction time is preferably in the range of 0. 5 to 24 hours, particularly preferably in the range of 2 to 5 hours. A reaction temperature is preferably in the range of -50 to 100°C, particularly preferably in the range of -20 to 50°C. If the reaction temperature exceeds 100°C, the product is apt to be gelled and heavily discolored. The use of a solvent as described below is effective in suppressing gelation and discoloring.

Any one of the solvents having no active hydrogen atoms such as those described in JP 04-164921 A and JP 04-258617 A can be used as the solvent.

That is, examples of an available solvent include: ketones such as acetone, methyl ethyl ketone, methyl isobutyl ketone, and cyclohexanone; aromatic solvents such as benzene, toluene, and xylene; ethers; aliphatic hydrocarbons; and esters.

The examples further include: a diacetate of ethylene glycol or of propylene glycol; a methyl ether acetate of ethylene glycol or of propylene glycol; and an acrylic monomer having neither an active hydroxyl group nor an active carboxyl group.

The amount of the solvent to be used is 0.2 to 5 fold amounts, preferably 0.5 to 3 fold amounts on a weight basis with respect to starting raw materials. An amount of the solvent to be used of less than 0.2 fold amount is not preferable because a product has a high viscosity, so the heat of reaction is hardly removed and the resultant product is discolored. An amount of the solvent to be used in excess of 5 fold amounts is not preferable either because a curing rate is slow and the physical properties of a cured product deteriorate when the polyether compound represented by the formula (4) having multiple polymerizable unsaturated groups and one or more acid groups in one molecule is used for a colored photosensitive composition for a color filter.

In addition, JP 04-258617 A mentioned above describes that a polymerization inhibitor such as hydroquinone, hydroquinone monomethyl ether, methyl hydroquinone, p-benzoquinone, or phenothiazine must be added at a concentration of 50 to 10,000 ppm to a reaction solution. However, during synthesis, a polymerization inhibitor having an active hydrogen atom reacts with a base to lose its effects. Therefore, in producing the polyether compound represented by the formula (4) in the present invention, an oxygen-containing gas such as air is preferably passed at the time of the reaction in order to prevent gelation. If an oxygen-containing gas such as air is not passed, gelation hardly occurs when a reaction molar ratio of the compound represented by the formula (2) to one molecule of the organic compound having an active hydrogen atom is less than 2, but starts to occur as the molar ratio of the formula (2) increases. In industrial production, a mixed gas with an oxygen concentration of approximately 7% is desirably prepared by mixing nitrogen and air from the viewpoint of safety.

Examples of the compound represented by the formula (2) include 3,4-epoxycyclohexylmethyl (meth)acrylate and ε-caprolactone-modified 3,4-epoxycyclohexylmethyl (meth)acrylate. Any one of vinylhexene monoepoxide, cyclohexene oxide, α-pinene oxide, epoxidized tetrahydrobenzyl alcohol, caprolactone-modified epoxidized tetrahydrobenzyl alcohol, and the like, which are not represented by the formula (2), can be used in the same manner as that of the compound represented by the formula (2).

Of those, 3,4-epoxycyclohexylmethyl (meth)acrylate (manufactured by Daicel Chemical Industries, Ltd., Cyclomer A-200 or the like) is preferable.

In a reaction between an organic compound RHₘ having an active hydrogen atom and an epoxy compound shown in the formula (2A) to obtain a polyether compound shown in the formula (3A) or a reaction between the RHₘ and an epoxy compound shown in the formula (2) to obtain a polyether compound shown in the formula (3), the RHₘ may react with an epoxy ring at the side close to R⁷ of the epoxy ring or the side close to R⁸. An example in which the RHₘ reacts with the epoxy ring at the side close to R⁷ is exemplarily shown in the formula (3A) or (3).

The polyether compound in the present invention represented by the formula (4) having multiple polymerizable unsaturated groups and one or more pieces of acid groups in one molecule can be obtained by further reacting the polyether compound of the formula (3) obtained as described above with a polybasic acid anhydride. A polybasic acid anhydride allowed to react is not particularly limited, and any one of a saturated polybasic acid anhydride, an unsaturated polybasic acid anhydride, and a dibasic acid anhydride containing an acid group such as a carboxyl group can be used. Examples of such a polybasic acid anhydride include succinic anhydride, maleic anhydride, phthalic anhydride, nadic anhydride, tetrahydrophthalic anhydride, tetrabromophthalic anhydride, hexahydrophthalic anhydride, methyltetrahydrophthalic anhydride, methylhexyahydrophthalic anhydride, endomethylenetetrahydrophthalic anhydride, methylendomethylenetetrahydrophthalic anhydride, methylbutenyltetrahydrophthalic anhydride, itaconic anhydride, octenyl succinic anhydride, pentadodecenyl succinic anhydride, chlorendic anhydride, biphenyltetracarboxylic monoanhydride/dianhydride, diphenylethertetracarboxylic monoanhydride/dianhydride, butanetetracarboxylic monoanhydride/dianhydride, cyclopentanetetracarboxylic monoanhydride/dianhydride, trimellitic anhydride, HET anhydride, himic anhydride, adipic anhydride, azelaic anhydride, sebacic anhydride, pyromellitic monoanhydride/dianhydride, and benzophenonetetracarboxylic dianhydride. Of those, succinic anhydride, phthalic anhydride, tetrahydrophthalic anhydride, and methyltetrahydrophthalic anhydride can be suitably used. Of those, an aliphatic polybasic acid anhydride is particularly preferable. In the present invention, one kind of polybasic acid anhydride can be used alone, or two or more kinds of polybasic acid anhydrides may be used in combination.

For example, when 3,4,5,6-tetrahydrophthalic anhydride, tetrahydrophthalic anhydride with another hydrogenation position, 4-methyltetrahydrophthalic anhydride, 3-methyltetrahydrophthalic anhydride, hexahydrophthalic anhydride, or 4-methylhexahydrophthalic anhydride is used, X in the polyether compound of the formula (4) to be obtained represents -COOH, so the compound has the following structural formula.

In each of the formulae (5A), (6A), and (7A), R¹⁴ represents an hydrogen atom or an alkyl group such as a methyl group.

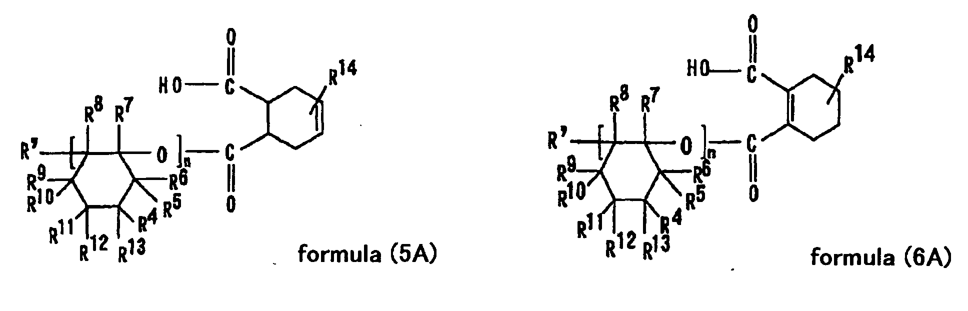

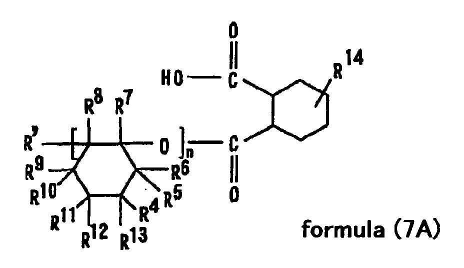

When X represents -OPO (OH)ₐ(OR)_{b} in the formula (4), phosphoric acid, ethyl phosphate, diethyl phosphate, a monoalkyl ester or dialkyl ester of glucose phosphate, or the like (phosphoric acid-based compound) is used instead of the polybasic acid anhydride.

When X represents -OSO₃R in the formula (4), sulfuric acid or an acidic sulfate such as ethyl sulfate or methyl sulfate, or the like (sulfuric acid-based compound) is used instead of the polybasic acid anhydride.

The reaction with the polybasic acid anhydride, the phosphoric acid-based compound, or the sulfuric acid-based compound can be performed by using a solution of a reactive diluent as it is without separating a reaction medium used at the time of the synthesis of the polyether compound of the formula (3), or may be performed after the separation of the reactive diluent. In addition, the polybasic acid anhydride may be dissolved for an addition reaction into, for example, an aromatic hydrocarbon such as toluene or xylene, an alcohol such as methanol, isopropanol, or cyclohexanol, an aliphatic hydrocarbon such as cyclohexane or methylcyclohexane, a petroleum-based solvent such as petroleum ether or petroleum naphtha, a cellosolve such as cellosolve or butylcellosolve, a carbitol such as carbitol or butylcarbitol, an acetate such as ethyl acetate, butyl acetate, cellosolve acetate, butylcellosolve acetate, carbitol acetate, or butylcarbitol acetate, or a ketone such as methyl ethyl ketone or cyclohexanone. In addition, a photopolymerizable monomer can be used as a reactive diluent in addition to any one of those organic solvents. Examples of a photopolymerizable monomer that can be used as a reactive diluent include: monofunctional acrylate compounds such as methyl (meth)acrylate, ethyl (meth)acrylate, n-propyl (meth)acrylate, n-butyl (meth)acrylate, 2-ethylhexyl (meth) acrylate, lauryl (meth)acrylate, stearyl (meth)acrylate, cyclohexyl (meth)acrylate, phenoxyethyl (meth)acrylate, 2-ethoxyethyl (meth)acrylate, 2-butoxyethyl (meth)acrylate, 2-hydroxyethyl (meth)acrylate, 2-hydroxypropyl (meth)acrylate, benzyl (meth)acrylate, and ethylcarbitol (meth)acrylate; and polyfunctional acrylates such as ethylene glycol di(meth)acrylate, polyethylene glycol di(meth)acrylate, neopentyl glycol di(meth)acrylate, trimethylolpropane di(meth)acrylate, trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, and polyfunctional epoxy acrylates.

In the present invention, each of those reactive diluents can be used alone, or two or more of them can be used in combination. In the present invention, the reaction between the polyether compound of the formula (3) and the polybasic acid anhydride is preferably performed at a reaction temperature in the range of 80 to 120°C in the presence of a polymerization inhibitor such as hydroquinone or methoquinone while a mixed gas containing oxygen is passed. If the reaction temperature is less than 80°C, a reaction rate may be slow and the reaction may require a long time period. If the reaction temperature exceeds 120°C, a polyfunctional acrylate causes thermal polymerization, so gelation may occur during the reaction. At this time, any one of the catalysts including: tertiary amines such as triethylamine; quaternary ammonium salts such as triethylbenzylammonium chloride; imidazole compounds such as 2-ethyl-4-methylimidazole; and phosphorous compounds such as triphenylphosphine may be optionally added.

As is apparent from the synthesis method described above, the polyether compound serving as a main resin component in the colored photosensitive composition for a color filter of the present invention is represented by the following formula (4) as a result of the ring-opening of the polybasic acid anhydride, and the reactions of the phosphoric acid-based or sulfuric acid-based compounds.

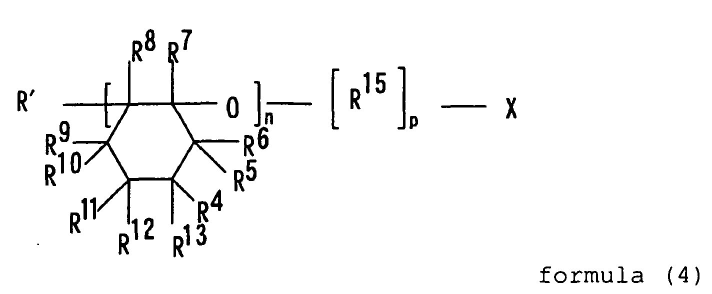

In the formula (4), R' represents a residue -RHₘ₋₁ of an organic compound RHₘ containing "m" pieces of active hydrogen atoms in one molecule, or a group derived from the residue; R represents a residue obtained by removing an active hydrogen atom from an organic compound having the active hydrogen atom; "m" represents an integer of 1 to 30; R⁴ to R¹³ each represent a hydrogen atom, a hydrocarbon group having 1 to 10 carbon atoms, or a hydrocarbon group having 1 to 10 carbon atoms and an unsaturated group, provided that the unsaturated group contains -OCO-CR³=CR¹R², R¹ and R² each represent a hydrogen atom, R³ represents a hydrogen atom or a hydrocarbon group having 1 to 10 carbon atoms, and at least one of R⁴ to R¹³ represents a hydrocarbon group having 1 to 10 carbon atoms and the unsaturated group; R¹⁵ represents a residue of a polybasic acid anhydride, phosphoric acid, ethyl phosphate, diethyl phosphate, a monoalkyl ester or dialkyl ester of glucose phosphate or the like, sulfuric acid, or an acidic sulfate such as ethyl sulfate or methyl sulfate; X represents -COOH, -OPO(OH)ₐ(OR)_{b}, or -OSO₃R (provided that R represents a hydrogen atom, a methyl group, or an ethyl group, "a" represents 1 or 0, and "a+b" = 2); "n" represents an integer of 1 or more, and it is essential that the number of structural units in the entire molecule represented by "n" be in the range of 2 to 50; and "p" represents 0 when X represents -OPO(OH)ₐ(OR)_{b} or -OSO₃R, while "p" represents an integer of 1 or more when X represents -COOH.

When the number of structural units is greater than 50, the number of unsaturated groups in the polyether compound represented by the formula (4) to be obtained becomes excessively many. Therefore, when the polyether compound is used as a curable resin, a cross-link density is so high that a cured film to be obtained becomes brittle, which is not preferable.

Furthermore, R¹⁵ represents a ring-opening residue of the polybasic acid anhydride or the like, and preferably contains an cycloaliphatic group.

The acid value (in terms of solid content) of the polyether compound represented by the formula (4) is in the range of 5 to 150 (KOHmg/g), typically 5 to 150 (KOHmg/g), preferably 25 to 150 (KOHmg/g) in view of alkali developability and sensitivity. An acid value of 5 or less (KOHmg/g) results in poor developability with a dilute alkaline aqueous solution. On the other hand, an acid value in excess of 300 (KOHmg/g) results in poor water resistance, poor alkali resistance, and poor humidity resistance of a coating film or color filter after curing.

When a polyvalent compound with "m" of 2 or more is used as the organic compound RHₘ containing "m" pieces of active hydrogen atoms in one molecule, R' in the formula (4) may include various cases where one to (m-1) pieces of active hydrogen atoms react to provide branched structures each having (m-1) pieces of structures similar to the structure obtained by removing R' in the formula (4) as well as -RHₘ₋₁ in which its active hydrogen atoms remain as they are. Similarly, R'' in the formula (3) may include various cases where one to (m-1) pieces of active hydrogen atoms react to provide branched structures each having (m-1) pieces of structures similar to the structure obtained by removing R" in the formula (3) as well as -RHₘ₋₁ in which its active hydrogen atoms remain as they are. The term " group derived from the residue" refers to such cases. To be specific, when trimethylolpropane is used as the organic compound containing "m" pieces of active hydrogen atoms in one molecule, in the formula (3), R'' may be a residue CH₃CH₂C(CH₂OH)₂CH₂O- (remaining active hydrogen atoms are unreacted), or may be one as a result of the reaction with the compound of the formula (2) using one or both of the two active hydrogen atoms in the compound as an origin of the reaction, that is, a "group derived from the residue" having one or two pieces of structures similar to the structure obtained by removing R'' in the formula (3) (provided that the numbers corresponding to "n" in the respective structures are equal to or different from each other). When all the two active hydrogen atoms in the residue are reacted, a total of three structures (the entire molecule is branched) can be obtained. The same holds true for an ether compound corresponding to the formula (4) obtained by further reacting the compound corresponding to the formula (3) in the case of trimethylolpropane with a polybasic acid anhydride or the like.

The colored photosensitive composition for a color filter of the present invention preferably contains 15% by weight or more of the polyether compound represented by the formula (4). The colored photosensitive composition for a color filter of the present invention is obtained by blending the polyether compound with a curable resin and/or an ethylenically unsaturated compound like a resin obtained by adding the compound represented by the formula (2A) toa (meth)acrylic acid-(meth)acrylate copolymer. Specific examples of the curable resin include "ACA200 or Cyclomer P" manufactured by and available from Daicel Chemical Industries, Ltd.

Specific examples of the ethylenically unsaturated compound include: β-carboxyethyl (meth)acrylate; isobonyl (meth)acrylate; octyldecyl (meth)acrylate; ethoxyphenyl (meth)acrylate; diethylene glycol monoethylether (meth)acrylate; t-butylcyclohexyl (meth)acrylate; dipropylene glycol di(meth)acrylate; 1, 6-hexanediol di(meth)acrylate; tripropylene glycol di(meth)acrylate; modified bisphenol A di(meth)acrylate; dimethyloldicyclopentane di(meth)acrylate; various PEG di(meth)acrylates such as diethylene glycol di(meth)acrylate, triethylene glycol di(meth)acrylate, and tetraethylene glycol di(meth)acrylate; trimethylolpropane tri(meth)acrylate; trimethylolpropane ethoxy tri(meth)acrylate; glycerin propoxy tri(meth)acrylate; caprolactone-modified trimethylolpropane tri(meth)acrylate; pentaerythritolethoxy tetra(meth)acrylate; ditrimethylolpropane tetra(meth)acrylate; pentaerythritol tetra(meth)acrylate; dipentaerythritol hexa(meth)acrylate; lauryl (meth)acrylate; butanediol di(meth)acrylate; bisphenol A ethoxylate di(meth)acrylate; lactone-modified flexible (meth)acrylate; 2-ethylhexyl (meth)acrylate; 2-hydroxyethyl (meth)acrylate; 2-hydroxypropyl (meth)acrylate; 2-hydroxyethyl (meth)acryloylphosphate; neopentyl glycol di(meth)acrylate; and hydroxy pivalate neopentyl glycol di(meth)acrylate.

In addition, the polyether compound represented by the formula (4) may be used in combination with any one of the other polymerizable oligomers such as various epoxy acrylates, urethane (meth)acrylates, unsaturated polyesters, polyester (meth)acrylates, polyether (meth)acrylates, and polymers of them.

The curable resin and/or the ethylenically unsaturated compound like a resin obtained by adding the compound represented by the formula (2A) to a (meth)acrylic acid-(meth)acrylate copolymer can be used alone, or two or more kinds of them can be mixed at an arbitrary ratio and used.

The curable resin and/or the ethylenically unsaturated compound like a resin obtained by adding the compound represented by the formula (2A) to a (meth)acrylic acid-(meth)acrylate copolymer are used in an amount in the range of 0 to 85% by weight, preferably 10 to 80% by weight, more preferably 50 to 80% by weight in the resin component. When the amount of the curable resin and/or the ethylenically unsaturated compound to be used exceeds 85% by weight, no effect of the use of the polyether compound represented by the formula (4) in a color filter is obtained. The curable resin and the ethylenically unsaturated compound can be synthesized according to conventionally known methods, and are easily available from the market.

The colored photosensitive (photo-curable) composition for a color filter of the present invention is obtained by combining the polyether compound having multiple polymerizable unsaturated groups and one or more pieces of acid groups in one molecule with a suitable coloring matter and the curable resin and/or the ethylenically unsaturated compound to be optionally added. Examples of an available photopolymerization initiator include benzophenone, orthobenzoyl methyl benzoate, 4-dimethylaminobenzoate (such as Kayacure EPA manufactured by Nippon Kayaku Co., Ltd.), 2,4-diethylthioxanthone (such as Kayacure DETX manufactured by Nippon Kayaku Co., Ltd.), 2-methyl-1-[4-(methyl)phenyl]-2-morpholinopropane(such as Irgacure 907 manufactured by Ciba-Geigy Ltd.), tetra(t-butylperoxycarbonyl)benzophenone, benzyl (that is, dibenzoyl), 2-hydroxy-2-methyl-1-phenyl-propan-1-on, 4,4-bisdiethylaminobenzophenone, and 2,2-bis(2-chlorophenyl)-4,5,4',5'-tetraphenyl-1,2'-biimidazole (such as B-CIM manufactured by Hodogaya Chemical, Ltd.). A photosensitizer may be optionally added.

Coloring matters to be incorporated into the colored photosensitive composition for a color filter of the present invention are composed of coloring matters of red, green, and blue called three primary colors of light and a coloring matter of black of a black matrix portion optionally used. Each of a dye and a pigment can be used as the coloring matter, but the pigment is preferable in terms of heat resistance and light resistance. Examples of such a pigment include: inorganic pigments such as barium sulfate, zinc white, lead sulfate, titanium oxide, yellow lead, red oxide, ultramarine blue, iron blue, chromium oxide, and carbon black; and organic pigments such as benzidine yellow G, benzidine yellow GR, sole fast orange 3GL, vulcan fast orange GC, pigment scarlet 3B, thiokundigomallon, phthalocyanine blue, phthalocyanine green, indanthrene blue, green gold, and malachite green lake. Specific examples of such a pigment are given below. All of them are represented by color index (C.I.) numbers. An organic pigment excellent in transparency is preferable as the pigment. C.I. yellow pigments 20, 24, 86, 93, 109, 110, 117, 125, 137, 138, 147, 148, 153, 154, 166, and 168, C.I. orange pigments 36, 43, 51, 55, 59, and 61, C.I. red pigments 9, 97, 122, 123, 149, 168, 177, 180, 192, 215, 216, 217, 220, 223, 224, 226, 227, 228, and 240, C.I. violet pigments 19, 23, 29, 30, 37, 40, and 50, C.I. blue pigments 15, 15:1, 15;4, 15:6, 22, 60, and 64, C.I. green pigments 7 and 36, C.I. brown pigments 23, 25, and 26, C.I. black pigment 7, titanium black, and the like.

A pigment having 50% by weight or more of primary particles each having a particle size of 0.3 µm or less and 5% by weight or less of primary particles each having a particle size of 1 µm or more is preferably used as a coloring matter from the viewpoints of the transparency and dispersability of a pigment. A pigment in which the particle sizes of all the primary particles are equal to or less than 0.1 µm and are sufficiently small as compared to the wavelength of visible light is more preferable. If the primary particles each having a particle size of 0.3 µm or less account for less than 50% by weight of all the particles or if the primary particles each having a particle size of 1 µm or more account for more than 5% by weight of all the particles, the transparency of the colored photosensitive composition for a color filter is poor. In particular, the composition is not suitable for color filter applications where transparency is required.

It should be noted that all the particles are composed of primary particles, secondary particles, and the like. A secondary particle is an agglomerate of primary particles.

The loading of the coloring matter in the colored photosensitive composition for a color filter is in the range of 50 to 1,000 parts by weight, preferably 50 to 500 parts by weight with respect to 100 parts by weight of the solid content of the colored photosensitive composition. When the loading of the coloring matter is lower than 50 parts by weight, characteristics as a filter are improved, but the filter thickness must be increased to obtain a predetermined optical density, so microprocessing becomes difficult.

The colored photosensitive composition for a color filter of the present invention may contain a thermal polymerization inhibitor, a pigment dispersant, and the like as additives as required. Furthermore, a thermoplastic resin, a thermosetting resin, and the like can be incorporated into the composition.

Appropriate addition of the pigment dispersant improves the pigment dispersability. The weight ratio of the pigment dispersant to the pigment is preferably in the range of 0.01 to 0.2, but is not necessarily limited to this range. Examples of an available pigment dispersant include: various surfactants such as cationic surfactants, anionic surfactants, and nonionic surfactants; and derivatives of organic pigments. Each of such dispersants provides a color filter excellent in transparency because of its excellent pigment dispersability and its great effect of preventing the reagglomeration of the pigments after the dispersion. Specific examples of cationic ones include Acetamin 24, Acetamin 86, and Cotamin 86P conc (each of which is manufactured by Kao Corporation), while specific examples of anionic ones include Demol P, Demol EP, Homogenol M-8, Homogenol L-18, Homogenol L-95, and Homogenol L-100 (each of which is manufactured by Kao Corporation). In addition, specific examples of nonionic ones include Emulgen A-60, Rheodol SP-L10, Rheodol SP-010, Emasol L-10H, and Emasol S-20 (each of which is manufactured by Kao Corporation). In addition, derivatives of organic pigments are particularly effective although their specifications differ from organic pigment to organic pigment. Examples of organic pigments serving as parent bodies include azo-based ones, phthalocyanine-based ones, quinacridone-based ones, anthraquinone-based ones, perylene-based ones, perynone-based ones, thioindigo-based ones, dioxazine-based ones, isoindolinone-based ones, quinophthalone-based ones, triphenylmethane-based ones, and metal complex salt-based ones. Derivatives of those organic pigments having substituents effective in dispersing pigments are used. Examples of the substituents include a hydroxyl group, a carboxyl group, a sulfonic group, a carbonamide group, a sulfoneamide group, and any one of the substituents represented by the following general formulae (18) to (23). A derivative having at least one kind of substituent selected from those substituents is used. A pigment and an organic pigment to be combined to serve as the parent body of the pigment are typically the same, but are not necessarily identical to each other.

-CH₂-X-A (18)

(X: an oxygen or sulfur atom, A: an aryl group)

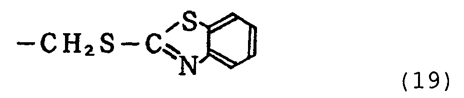

-CH₂OX-NR¹R² (20)

(X: an alkylene group, R¹, R²: a hydrogen atom or an alkyl group, or R¹ and R² bind to form a heterocyclic ring containing at least a nitrogen atom)

-CH₂NR¹R² (21)

(R¹: a hydrogen atom, an alkyl group, or an aryl group, R²: an alkyl group or an aryl group, or R¹ and R² bind to form a heterocyclic ring containing at least a nitrogen atom)

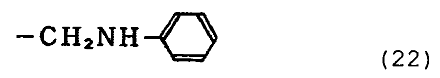

-SO₂NR¹-A-NR²R³ (23)

(R¹: a hydrogen atom or an alkyl group, A: an alkylene group, R²: an alkyl group, an alkoxyalkyl group, or a cycloalkyl group, R³: a hydrogen atom or a cycloalkyl group, or R² and R³ bind to form a heterocyclic ring containing at least a nitrogen atom)

Furthermore, each of the amino group-containing lactones each represented by the following formula (24) can be used as the pigment dispersant.

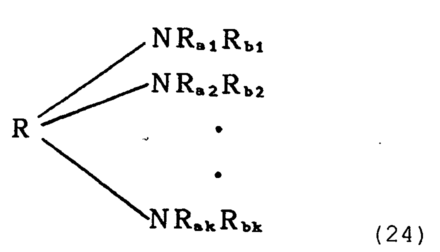

In the formula,
R represents a residue of aliphatic, alicyclic, and aromatic hydrocarbons, and an N atom may form a ring with R or R may have a substituent;
at least one of Rₐ₁, ··· Rₐₖ, and R_{b1}, ··· R_{bx} represents a substituent represented by the general formula (25), and the others each independently represent a hydrogen atom or an alkyl group having 1 to 10 carbon atoms; and
k represents an integer of 1 to 5.

   -CH₂-CHR¹-COO-R²-O-(-CO-R³-O-)ₙ-H (25)

In the formula,
R¹ represents a hydrogen atom or a methyl group;
R² represents an aliphatic or aromatic hydrocarbon group having 1 to 10 carbon atoms, a polypropyleneoxy unit, or a polyethyleneoxy unit, and may have a substituent;
R³ represents an alkylene group having 3 to 10 carbon atoms which may have a side chain having 1 to 5 carbon atoms, and "n" pieces of R³'s may be identical to or different from each other; and
"n" represents an integer of 1 to 100 on average.

Alternatively, an amino group-containing compound represented by the following general formula (26) can also be used as the pigment dispersant. That is, a polyester compound represented by the general formula (26) can be used, which contains, as an essential ingredient, a unit having: a functional group capable of causing a Michael addition reaction with an amino group at its terminal; and a polyester chain produced by ring-opening of a lactone compound represented by the general formula (27).

X-Y-R (26)

In the formula, X represents a unit having a functional group capable of causing a Michael addition reaction with an amino group at its terminal; Y represents a unit having a polyester chain produced by ring-opening of a lactone compound (27); 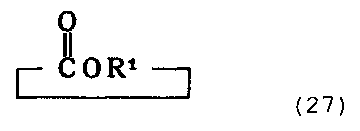 [In the formula (27), R¹ represents an alkylene group having 1 to 10 carbon atoms which may be substituted by an aliphatic alkyl group having 1 to 10 carbon atoms],
and R represents an alkyl group having 1 to 20 carbon atoms, an aromatic group, an OH group, a cyano group, or a halogen atom.

In a method of producing a color filter using the colored photosensitive composition for a color filter of the present invention, at first, the composition is applied onto a glass substrate or the like serving as a transparent substrate by means of a coating method such as spray coating, spin coating, or slit coating. The dried coating film has a thickness in the range of 1 to 3 µm, and is exposed to ultraviolet rays while being in contact with or out of contact with a positive or negative mask having a predetermined pattern. After that, the resultant is immersed in an alkali developer, or an alkali developer is sprayed onto the resultant by means of a spray or the like to remove an uncured portion. Subsequently, a similar operation is repeated. Furthermore, heating can be performed as required for the purpose of promoting the polymerization of the photosensitive resin.

An aqueous solution of sodium carbonate decahydrate, trialkylammonium hydroxide, caustic soda, or the like can be used as the alkali developer at the time of development. An amine such as dimethylbenzylamine or triethanolamine, or a trialkylammonium halide can be also added. After the colored composition for a color filter has been applied and dried, a water-soluble or alkali-soluble resin such as a water-soluble acrylic resin or a polyvinyl alcohol resin may be applied and dried before exposure to ultraviolet rays in order to increase sensitivity to exposure to ultraviolet rays.

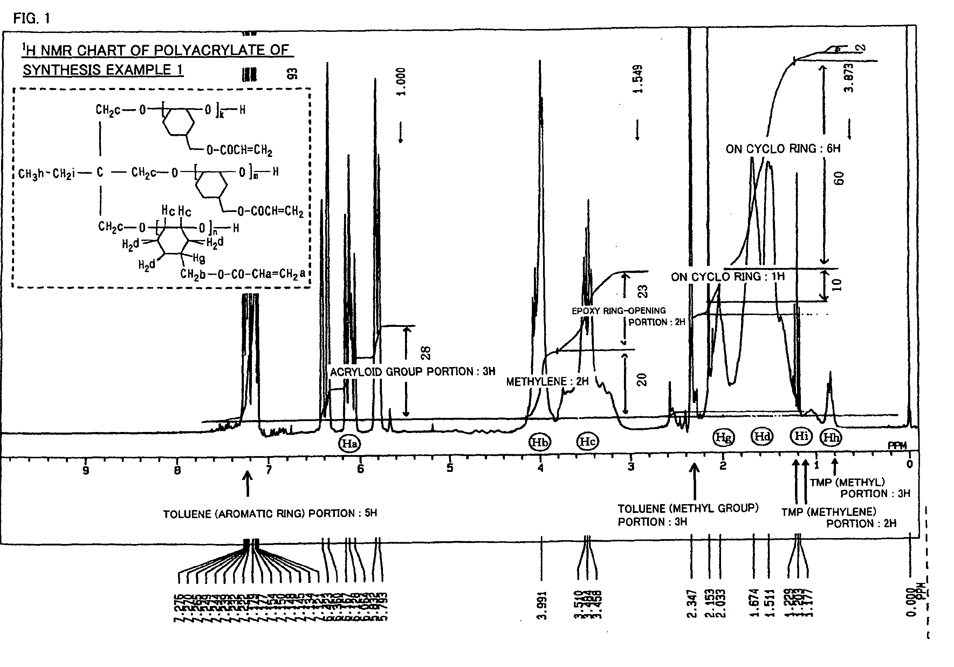

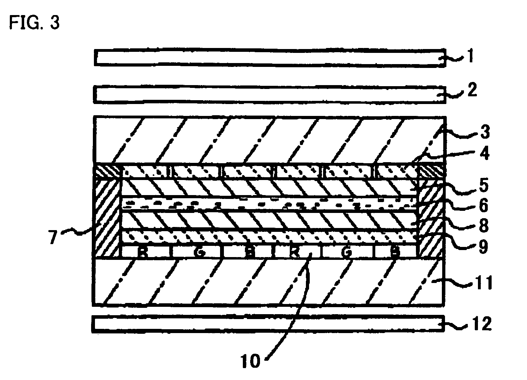

One shown in Fig. 1 of JP 02-144502 mentioned above can be applied as it is as an example of application of a color filter using the colored photosensitive composition for a color filter of the present invention to a liquid crystal display device. The example is shown in Fig. 3 of this description, and a description will be made with reference to the figure. In other words, Fig. 3 shows an example of a liquid crystal display device using a color filter. White light emitted from a light source 1 such as a fluorescent tube passes through a pixel electrode 4 and an alignment layer 5 via a polarizing plate 2 and a transparent substrate 3 to travel toward a liquid crystal 6. Furthermore, the light passes through an alignment film 8 and a transparent electrode 9 to be separated into three primary colors by a color filter 10. Furthermore, the light passes through a transparent substrate 11 and a polarizing plate 12 to be visually identified as a color. In such a display device, the liquid crystal 6 is sealed between the alignment films 5 and 8 so as to be in contact with a sealer 7, and changes its orientation by means of an electrical signal applied between the pixel electrode 4 and the transparent electrode 9. At this time, the polarizing plates 2 and 12 serve as optical shutters to convert the light that has passed through the color filter into information. The size of each color of the color filter 10 is the same as that of the pixel electrode 4, and is of a several millimeter-square for a large display or a several tens of micron to several hundreds of micron-square for a handy-type display. Therefore, the color filter 10 must be composed of a material that can be subjected to microprocessing.

Subsequently, the configuration of the color filter of the present invention will be described below. A glass substrate, a transparent resin plate, a transparent resin film, or the like is applicable as the transparent substrate 11 shown in Fig. 3. In general, the color filter 10 is placed on the transparent substrate 11 and the transparent electrode 9 is arranged on the color filter 10. However, in some cases, a transparent electrode is arranged on the transparent substrate 11 and a color filter is placed on the electrode. As shown in Fig. 3, the color filter 10 is composed of, for example, a red filter layer R, a green filter layer G, and a blue filter layer B. In some cases, a black or opaque light-shielding or uncolored layer is placed between two arbitrary layers of the R, G, and B layers. The red filter layer R is mainly composed of: a polyether compound having multiple polymerizable unsaturated groups and one or more acid groups in one molecule; a curable resin and/or an ethylenically unsaturated compound to be optionally added; a red pigment; and a pigment dispersant. Similarly, each of the green filter layer G and the blue filter layer B is mainly composed of: the polyether compound; the curable resin and/or the ethylenically unsaturated compound to be optionally added; a pigment; and a pigment dispersant. The roles of the polyether compound and the curable resin and/or the ethylenically unsaturated compound to be optionally added are: to fix a pigment of each color onto the transparent substrate 11; to optionally enable patterning in an arbitrary shape; and to serve as a base when the transparent electrode 9 is formed on the color filter 10.

### EXAMPLES

Hereinafter, the present invention will be described more specifically by way of examples. However, the present invention is not limited to these examples.

The term "part" means "part by weight" in the examples.

### Synthesis of various polyethers

### (Synthesis Example 1)

Fed into a 5-liter reactor equipped with a stirrer, a temperature control unit, and a thermometer were 134.2 parts of trimethylolpropane (TMP) serving as an organic compound RHₘ having active hydrogen atoms (described as an initiator in the following tables), 2,730 parts of 3,4-epoxycyclohexylmethyl acrylate (manufactured by Daicel Chemical Industries, Ltd., Cyclomer A-200, indicated by A-200 in a table) as a compound having the structure of the formula (2), and 1,540 parts of toluene, and the liquid temperature was increased to 35°C. Subsequently, 41 parts of diethyl ether complex of boron trifluoride were dropped into the liquid over about 3 hours to carry out a reaction. After the completion of the dropping, the reaction was continued until an oxirane oxygen concentration in the mixed liquid became 0.05% or less. A mixed gas of nitrogen and air with an oxygen concentration of 7% was passed through the liquid at 83 ml/min by the end of the reaction in order to prevent gelation due to radical polymerization during the reaction.

The solid content (solid dried for 1 hour at 120°C), viscosity, and molecular weight by GPC of the resultant compound corresponding to the formula (3) (which is referred to as a polyacrylate-based compound here, but may be referred to as a polymethacrylate-based compound depending on a raw material used in the following synthesis examples) were as follows.

Solid content 65.4%, viscosity (25°C) 181 cps, acid value = 2.5 KOHmg/g, Mw = 3,640, Mn = 1,760

The resultant polyacrylate-based compound in the form of a toluene solution was directly subjected to ¹H-NMR measurement to identify the structure. Fig. 1 shows the NMR chart.

In the NMR chart of Fig. 1, toluene serving as the solvent showed peaks at 7.2 ppm (part of the peak is hidden by a chemical formula) and 2.3 ppm. The absorption by the polyacrylate-based compound obtained as described above had a peak of 3H by an acryloyl group at 6.4 to 5.8 ppm, a peak of methylene 2H sandwiched between a cyclo ring and an acryloid at 4 ppm, and a peak of an epoxy ring-opening portion 2H at 3.5 ppm as a main peak on which 2H protons of methylene adjacent to a hydroxyl group of TMP and a 1H proton of a hydroxyl group at the terminal of the resin overlapped. Furthermore, a peak at 2.0 ppm corresponded to a 1H proton attached to tertiary carbon on the cyclo ring and a peak at 1.9 to 1.2 ppm was the peak of 6H attached to secondary carbon on the cyclo ring. It can be confirmed that each proton intensity ratio was substantially the theoretical value and the epoxy portion of the formula (2) was completely ring-opened.

In addition, an intensity ratio between a methyl portion (CH₃: 3H) of trimethylolpropane used as an initiator of the ring-opening and a 1H proton attached to tertiary carbon on the cyclo ring was 2:10, so it can be confirmed that the value coincides with the theoretical value of 1:15 derived from the feeding molar ratio.

The polyacrylate-based compound obtained as described above was further subjected to an addition reaction with tetrahydrophthalic anhydride as a dibasic acid anhydride as follows.

Fed into a 500-ml reactor equipped with a stirrer, a temperature control unit, and a thermometer were 300 parts of the solution of the polyacrylate-based compound in toluene obtained as described above (solid content: 65%), 31 parts of tetrahydrophthalic anhydride, and 0.33 part of hydroquinone monomethyl ether, and the liquid temperature was increased to 90°C. Subsequently, 0.83 part of imidazole was added to the liquid to advance an addition reaction. Sampling was performed with time during the reaction to perform an acid value measurement and a GPC measurement. The reaction was continued for 10 hours, and it was confirmed that: the acid value was 36 KOHmg/g (acid value in terms of solid content = 51 KOHmg/g), while the theoretical value of the reaction was 35 KOHmg/g; and a peak by tetrahydrophthalic anhydride at lower molecular weight substantially completely disappeared in the GPC measurement.

The solid content (dried for 1 hour at 120°C), viscosity, and molecular weight by GPC of the resultant polyether compound of the formula (4) (which is referred to as an acid anhydride-added polyacrylate-based compound here, but may be referred to as an acid anhydride-added polymethacrylate-based compound depending on a raw material used in the following synthesis examples) were as follows.

Solid content 69.2%, viscosity (25°C) 1,600 cps, Mw = 3,740, Mn = 1,810

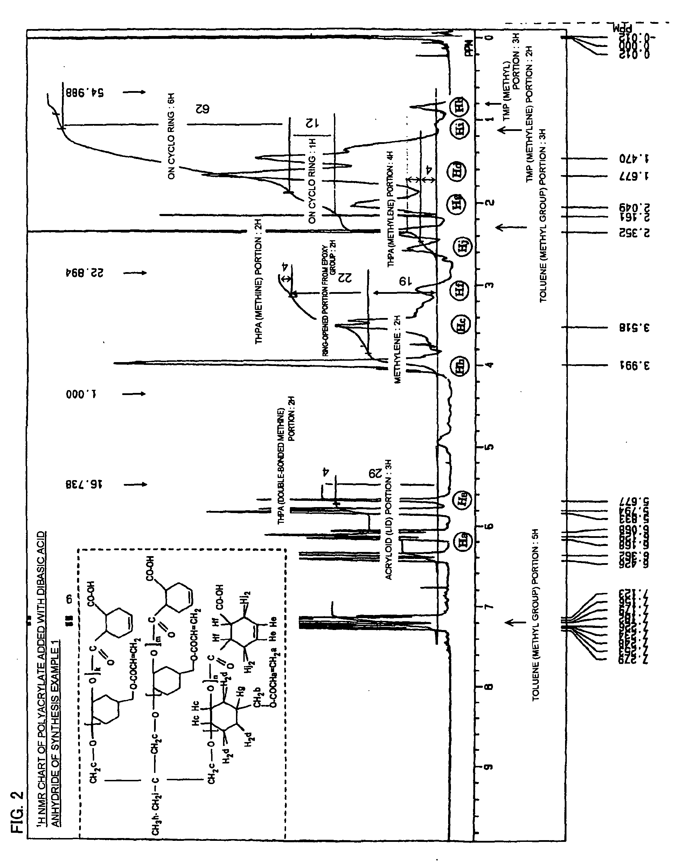

The dibasic acid anhydride-added polyacrylate-based compound in the form of a toluene solution was directly subjected to ¹H-NMR measurement to identify the structure. Fig. 2 shows the NMR chart.

In the NMR chart of Fig. 2, toluene serving as the solvent showed proton peaks at 7.2 ppm (part of the peak is hidden by a chemical formula) and 2.3 ppm. The following three peaks by tetrahydrophthalic anhydride (THPA) are added to the NMR chart of Fig. 1. First, a peak at 5.7 ppm in lower magnetic fields was the peak by methine in a double-bond portion of THPA and a peak at 3.0 ppm was the peak by methine of tertiary carbon to which the ester of THPA was adjacent. Those two signal are observed at 6.0 ppm and 3.4 ppm, respectively in a THPA alone and a sample at an initial stage of the reaction, but their peak positions shift as a result of binding with a polyacrylate compound. Finally, the absorption of 4H of the methylene portion of THPA was observed to be divided into the absorption of 2H at 2.6 ppm and the absorption of 2H at 2.3 ppm. It was confirmed that: the peak at 2.3 ppm overlapped with the absorption by the methyl group of toluene; and the proton intensity ratios at 5.7, 3.0, and 2.6 ppm were substantially equal. In addition, a ratio between those intensities and methylene 2H sandwiched between the acryloyl group and the cyclo ring was 4:19, so it can be confirmed that the value coincides with 3:15 derived from the feeding molar ratio.

### (Synthesis Example 2)

Fed into a 3-liter reactor equipped with a stirrer, a temperature control unit, and a thermometer were 134.2 parts of trimethylolpropane (TMP), 1,092 parts of 3,4-epoxycyclohexylmethyl acrylate (manufactured by Daicel Chemical Industries, Ltd., Cyclomer A-200) as a compound having the structure of the formula (2), and 650 parts of toluene, and the liquid temperature was increased to 35°C. Subsequently, 16. 4 parts of diethyl ether complex of boron trifluoride were dropped into the liquid over about 3 hours to carry out a reaction. After the completion of the dropping, the reaction was continued until an oxirane oxygen concentration in the mixed liquid became 0.05% or less. A mixed gas of nitrogen and air with an oxygen concentration of 7% was passed through the liquid at 50 ml/min by the end of the reaction in order to prevent gelation due to radical polymerization during the reaction.

The solid content (dried for 1 hour at 120°C), viscosity, and molecular weight by GPC of the resultant polyacrylate-based compound were as follows.

Solid content 64.5%, viscosity (25°C) 98 cps, acid value = 2.0 KOHmg/g, Mw = 1,410, Mn = 1,020

The polyacrylate-based compound obtained as described above was further subjected to an addition reaction with tetrahydrophthalic anhydride as a dibasic acid anhydride as follows.

Fed into a 500-ml reactor equipped with a stirrer, a temperature control unit, and a thermometer were 300 parts of the solution of the polyacrylate-based compound of the formula (3) in toluene (solid content: 65%), 72.5 parts of tetrahydrophthalic anhydride, and 0.33 part of hydroquinone monomethyl ether, and the liquid temperature was increased to 90°C. Subsequently, 0.83 part of imidazole was added to the liquid to advance an addition reaction. Sampling was performed with time during the reaction to perform an acid value measurement and a GPC measurement. The reaction was continued for 10 hours, and it was confirmed that: the acid value was 74 KOHmg/g (acid value in terms of solid content = 103 KOHmg/g), while the theoretical value of the reaction was 72 KOHmg/g; and a peak by tetrahydrophthalic anhydride at lower molecular weight substantially completely disappeared in the GPC measurement.

The solid content (dried for 1 hour at 120°C), viscosity, and molecular weight by GPC of the resultant acid anhydride-added polyacrylate-based compound were as follows.

Solid content 71.8%, viscosity (25°C) 1,150 cps, Mw = 1,550, Mn = 1,180

### (Synthesis Example 3)

Fed into a 3-liter reactor equipped with a stirrer, a temperature control unit, and a thermometer were 134.2 parts of trimethylolpropane (TMP), 1,176 parts of 3,4-epoxycyclohexylmethyl methacrylate (manufactured by Daicel Chemical Industries, Ltd., Cyclomer M-100, indicated by M-100 in a table) as a compound having the structure of the formula (2), and 695 parts of toluene, and the liquid temperature was increased to 35°C. Subsequently, 17.6 parts of diethyl ether complex of boron trifluoride were dropped into the liquid over about 3 hours to carry out a reaction. After the completion of the dropping, the reaction was continued until an oxirane oxygen concentration in the mixed liquid became 0.05% or less. A mixed gas of nitrogen and air with an oxygen concentration of 7% was passed through the liquid at 50 ml/min by the end of the reaction in order to prevent gelation due to radical polymerization during the reaction. The solid content (dried for 1 hour at 120°C), viscosity, and molecular weight by GPC of the resultant polymethacrylate-based compound were as follows.

Solid content 65.2%, viscosity (25°C) 90 cps, acid value = 1.5 KOHmg/g, Mw = 1,480, Mn = 1,090

The polymethacrylate-based compound obtained as described above was further subjected to an addition reaction with tetrahydrophthalic anhydride as a dibasic acid anhydride as follows.

Fed into a 500-ml reactor equipped with a stirrer, a temperature control unit, and a thermometer were 300 parts of the solution of the polymethacrylate-based compound in toluene (solid content: 65%), 71 parts of tetrahydrophthalic anhydride, and 0.33 part of hydroquinone monomethyl ether, and the liquid temperature was increased to 90°C. Subsequently, 0.83 part of imidazole was added to the liquid to advance an addition reaction. Sampling was performed with time during the reaction to perform an acid value measurement and a GPC measurement. The reaction was continued for 10 hours, and it was confirmed that: the acid value was 73 KOHmg/g (acid value in terms of solid content = 100 KOHmg/g), while the theoretical value of the reaction was 71 KOHmg/g; and a peak by tetrahydrophthalic anhydride at lower molecular weight substantially completely disappeared in the GPC measurement.

The solid content (dried for 1 hour at 120°C), viscosity, and molecular weight by GPC of the resultant acid anhydride-added acrylate-based compound were as follows: solid content 73.0%, viscosity (25°C) 1,460 cps, Mw = 1,570, Mn = 1,200

### (Synthesis Example 4)

Fed into a 2-liter reactor equipped with a stirrer, a temperature control unit, and a thermometer were 72 parts of acrylic acid (AA), 910 parts of 3,4-epoxycyclohexylmethyl acrylate (manufactured by Daicel Chemical Industries, Ltd., Cyclomer A-200) as a compound having the structure of the formula (2), and 520 parts of toluene, and the liquid temperature was increased to 35°C. Subsequently, 13.7 parts of diethyl ether complex of boron trifluoride were dropped into the liquid over about 3 hours to carry out a reaction. After the completion of the dropping, the reaction was continued until an oxirane oxygen concentration in the mixed liquid became 0.05% or less. A mixed gas of nitrogen and air with an oxygen concentration of 7% was passed through the liquid at 33 ml/min by the end of the reaction in order to prevent gelation due to radical polymerization during the reaction. The solid content (dried for 1 hour at 120°C), viscosity, and molecular weight by GPC of the resultant polyacrylate-based compound were as follows.

Solid content 65.4%, viscosity (25°C) 75 cps, Mw = 1,380, Mn = 940

The polyacrylate-based compound obtained as described above was further subjected to an addition reaction with tetrahydrophthalic anhydride as a dibasic acid anhydride as follows.

Fed into a 500-ml reactor equipped with a stirrer, a temperature control unit, and a thermometer were 300 parts of the solution of the polyacrylate-based compound in toluene (solid content: 65%), 30.2 parts of tetrahydrophthalic anhydride, and 0.33 part of hydroquinone monomethyl ether, and the liquid temperature was increased to 90°C. Subsequently, 0.83 part of imidazole was added to the liquid to advance an addition reaction. Sampling was performed with time during the reaction to perform an acid value measurement and a GPC measurement. The reaction was continued for 10 hours, and it was confirmed that: the acid value was 35 KOHmg/g (acid value in terms of solid content = 51 KOHmg/g), while the theoretical value of the reaction was 34 KOHmg/g; and a peak by tetrahydrophthalic anhydride at lower molecular weight substantially completely disappeared in the GPC measurement.

The solid content (dried for 1 hour at 120°C), viscosity, and molecular weight by GPC of the resultant acid anhydride-added polyacrylate-based compound were as follows: solid content 68.6%, viscosity (25°C) 1,230 cps, Mw = 1,440, Mn = 1,010

### (Synthesis Example 5)

Synthesis was performed in the same manner as in Synthesis Example 1 except that 1,540 parts of toluene as a reaction medium were changed to 740 parts of isobonyl acrylate and 800 parts of n-butyl acrylate.

The solid content (dried for 120°C * 1 hour), viscosity, molecular weight by GPC, and the like of the resultant polyacrylate-based compound were as follows.

Solid content 65.0%, viscosity (25°C) 780 cps, Mw = 2,380, Mn = 1,460

The polyacrylate-based compound was further subjected to an addition reaction with tetrahydrophthalic anhydride as a dibasic acid anhydride in the same manner as in Synthesis Example 1 to yield an acid anhydride-added polyacrylate-based compound having the following physical properties.

Solid content 70.1%, viscosity (25°C) 2,950 cps, Mw = 3,310, Mn = 1,690

### (Comparative Synthesis Example 1)

Fed into a 2-liter reactor equipped with a stirrer, a temperature control unit, and a thermometer were 72 parts of acrylic acid (AA), 910 parts of 3,4-epoxycyclohexylmethyl acrylate (manufactured by Daicel Chemical Industries, Ltd., Cyclomer A-200) as a compound having the structure of the formula (2), 165 parts of toluene, and 0.91 part of hydroquinone monomethyl ether as a polymerization inhibitor, and the liquid temperature was increased to 35°C. Subsequently, 13.7 parts of diethyl ether complex of boron trifluoride were dropped into the liquid over about 3 hours to carry out a reaction. However, a mixed gas of nitrogen and air was not passed during the reaction. As a result, gelation occurred.

### (Comparative Synthesis Example 2)

Fed into a 2-liter reactor equipped with a stirrer, a temperature control unit, and a thermometer were 134.2 parts of trimethylolpropane (TMP), 620 parts of vinylcyclohexene monoepoxide (manufactured by Daicel Chemical Industries, Ltd., CEL 2000), and 360 parts of toluene, and the liquid temperature was increased to 35°C. Subsequently, 12.4 parts of diethyl ether complex of boron trifluoride were dropped into the liquid over about 3 hours to carry out a reaction. After the completion of the dropping, the reaction was continued until an oxirane oxygen concentration in the mixed liquid became 0. 05% or less. A mixed gas of nitrogen and air with an oxygen concentration of 7% was passed through the liquid at 83 ml/min by the end of the reaction in order to prevent gelation due to radical polymerization during the reaction.

The viscosity, molecular weight by GPC, and the like of the resultant compound were as follows.

Solid content = 65.0%, viscosity (25°C) 135 cps, acid value 2.7 KOHmg/g, Mw = 1,980, Mn = 970

The compound (A) obtained as described above was further subjected to an addition reaction with tetrahydrophthalic anhydride as a dibasic acid anhydride as follows.

Fed into a 500-ml reactor equipped with a stirrer, a temperature control unit, and a thermometer were 300 parts of the solution (solid content: 65%) of the compound (A) in toluene, 42.8 parts of tetrahydrophthalic anhydride, and 0.33 part of hydroquinone monomethyl ether, and the liquid temperature was increased to 90°C. Subsequently, 0.83 part of imidazole was added to the liquid to advance an addition reaction. Sampling was performed with time during the reaction to perform an acid value measurement and a GPC measurement. The reaction was continued for 10 hours, and it was confirmed that: the acid value was 48 KOHmg/g (acid value in terms of solid content = 69 KOHmg/g), while the theoretical value of the reaction was 46 KOHmg/g; and a peak by tetrahydrophthalic anhydride at lower molecular weight substantially completely disappeared in the GPC measurement.

The solid content (dried for 1 hour at 120°C), viscosity, and molecular weight by GPC of the resultant acid anhydride-added compound were as follows: solid content = 70.7%, viscosity (25°C) 1,300 cps, Mw = 2,010, Mn = 1,040

### (Comparative Synthesis Example 3)

The following synthesis was performed as one comparative synthesis example in order to obtain: an epoxy (meth)acrylate resin obtained by subjecting an epoxy group of an epoxy resin described in JP 06-157965 A to a ring-opening reaction with acrylic acid (AA) or methacrylic acid; and a product obtained by adding an acid anhydride to the epoxy (meth)acrylate resin.

Fed into a 2-liter reactor equipped with a stirrer, a temperature control unit, and a thermometer were 1,000 parts of an epoxidized cyclohexane polyether resin EHPE 3150 (an epoxidized product of a product as a result of a reaction between 1 mole of trimethylolpropane and 15 moles of vinylcyclohexene monoepoxide, manufactured by Daicel Chemical Industries, Ltd., epoxy equivalent of 178) produced according to a method described in JP 60-166675 A, 602 parts of propylene glycol monomethylether acetate (MMPG-Ac), and 21.0 parts of dimethylbenzylamine, and the liquid temperature was increased to 100°C to dissolve EHPE 3150. After that, 202 parts of acrylic acid at which an equivalent ratio was established between an epoxy group and a carboxyl group were dropped into the liquid over 1 hour, and the whole was further aged at 100°C for 7 hours, followed by sampling.

A sample had a measured acid value of 26 KOHmg/g. The mixture was heated to 110°C and the aging was continued for 3 hours before sampling was performed again. Thus, it was confirmed that the acid value was 4 KOHmg/g. It should be noted that a mixed gas of nitrogen and air with an oxygen concentration of 7% was passed through the liquid (17 ml/min) by the end of the reaction and the aging in order to prevent gelation.

The viscosity, molecular weight by GPC, and the like of the resultant compound were as follows.

Solid content = 65.5%, acid value 4.8 KOHmg/g, viscosity (25°C) 2,150 cps, Mw = 3,270, Mn = 1,460

The compound obtained as described above was further subjected to an addition reaction with tetrahydrophthalic anhydride as a dibasic acid anhydride as follows.

Fed into a 500-ml reactor equipped with a stirrer, a temperature control unit, and a thermometer were 300 parts of the solution of the compound in MMPG-Ac (solid content: 65%), 28.1 parts of tetrahydrophthalic anhydride, and 0.33 part of hydroquinone monomethyl ether, and the liquid temperature was increased to 90°C. Subsequently, 0.83 part of imidazole was added to the liquid to advance an addition reaction. Sampling was performed with time during the reaction to perform an acid value measurement and a GPC measurement. The reaction was continued for 10 hours, and it was confirmed that: the acid value was 33 KOHmg/g (acid value in terms of solid content = 48 KOHmg/g), while the theoretical value of the reaction was 32 KOHmg/g; and a peak by tetrahydrophthalic anhydride at lower molecular weight substantially completely disappeared in the GPC measurement.

The solid content (dried for 120°C * 1 hour), viscosity, and molecular weight by GPC of the resultant acid anhydride-added polyether compound were as follows.

Solid content =68. 8%, viscosity (25°C) 6,350 cps, Mw = 3, 570, Mn = 1,550

Table 1 and Table 2 below collectively show the reaction compositions in Synthesis Examples and Comparative Synthesis Examples and the physical properties of the resultant mixed liquids.

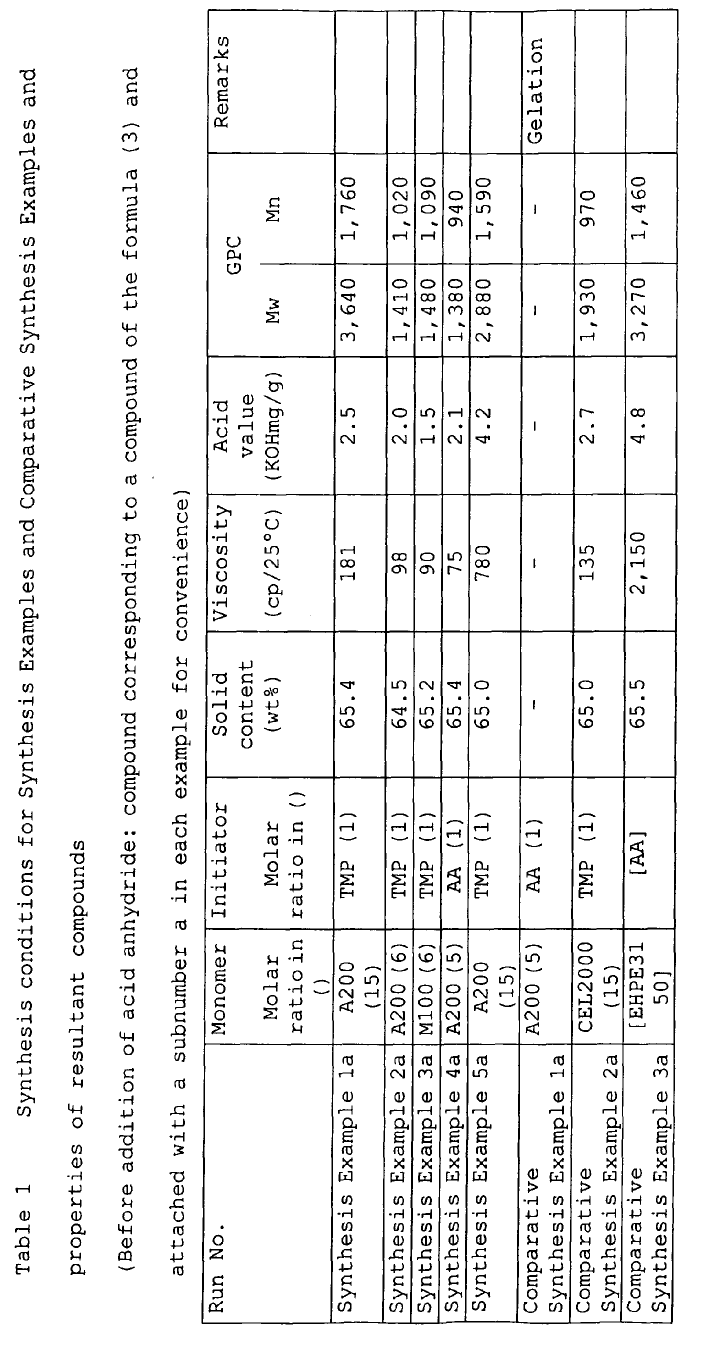

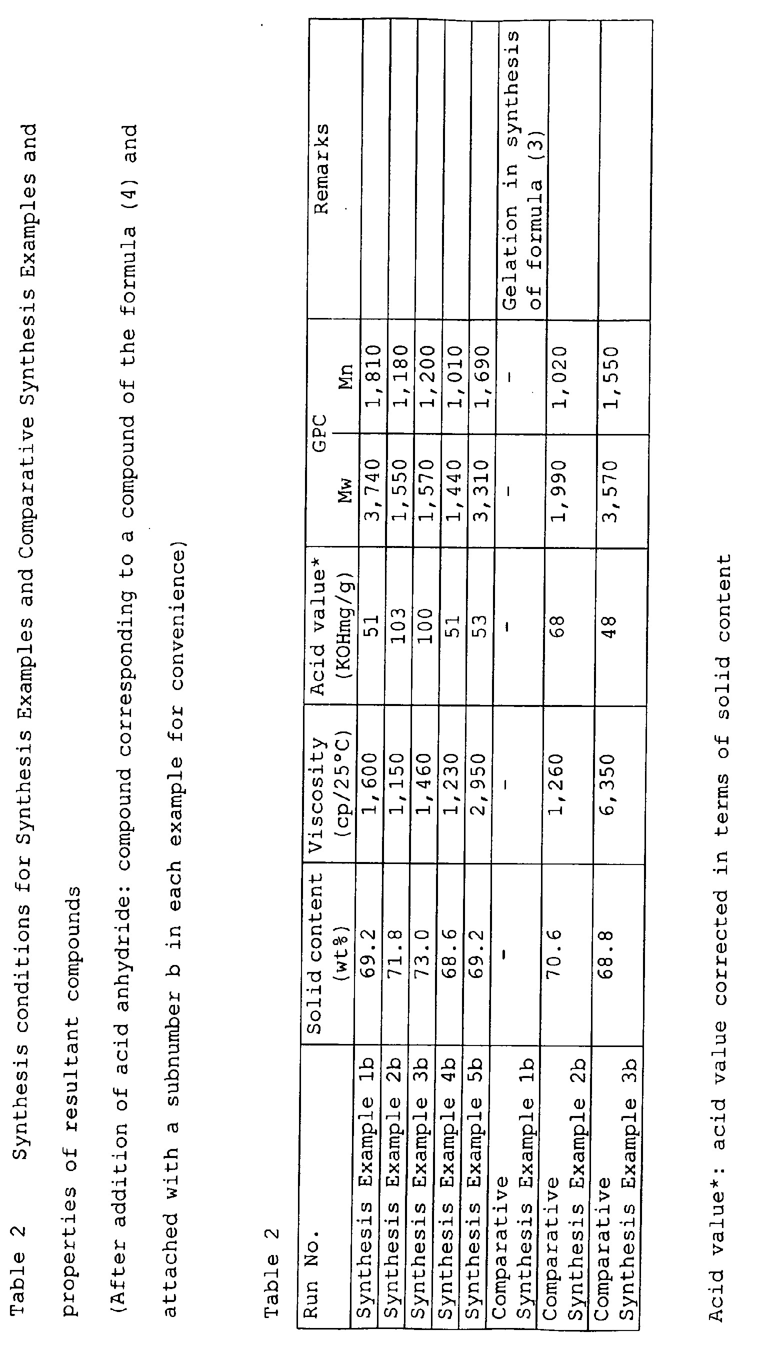

### Evaluation of UV-cured product

A commercially available product (ACA 200 manufactured by Daicel Chemical Industries, Ltd.) obtained by adding 3,4-epoxycyclohexylmethyl acrylate to a methacrylic acid-methyl methacrylate copolymer used in a field of an alkali development type resist was used to prepare resists of R (red), G (green), and B (blue) according to the followingmethod. After that, those resists were blended and cured with UV to evaluate tackiness, resolution, and the like.

The above polyether compounds were represented by Synthesis Examples "1a" to "5a" and Comparative Synthesis Examples "2b" and "3b", and a system in which the polyacrylate-based compound of Synthesis Example 1 before the addition of a dibasic acid anhydride was blended was represented by Comparative Synthesis Example "4b". Furthermore, a system in which commercially available general-purpose hexafunctional DPHA (dipentaerythritol hexaacrylate having 6 acryloyl groups) was blended and a system in which none of the above was blended were added for comparison.

### (Example 1: Preparation of a red-colored resist)

100 parts of the commercially available product (ACA 200 manufactured by Daicel Chemical Industries, Ltd., solid content of 47%), 50 parts of the polyether compound synthesized in Synthesis Example 1 (Synthesis Example 1b), 57.6 parts of Rionogen Red GD (manufactured by Toyo Ink MFG. Co., Ltd.) and 19. 2 parts of Rionogen Yellow 3G (manufactured by Toyo Ink MFG. Co., Ltd.) as coloring matters, 4.08 parts of a dispersant "Emulgen A-60" (hereinafter, all the dispersants are the same), and 343.1 parts of methylpropylene glycol acetate were mixed, and the mixture was sufficiently dispersed by means of a sand mill to prepare a red paste. Subsequently, 524.5 parts of the red paste, 0.96 part of Irgacure 907 (manufactured by Ciba-Geigy Ltd.), 0.96 part of Kayacure DETX (manufactured by Nippon Kayaku Co., Ltd.), 0.48 part of Kayacure EPA (manufactured by Nippon Kayaku Co., Ltd.), and 254.6 parts of methylpropylene glycol acetate were sufficiently mixed in a vessel capable of performing stirring to prepare a red resist with a non-volatile component content of about 20%.

### (Example 2: Preparation of a green-colored resist)

100 parts of the commercially available product (ACA 200 manufactured by Daicel Chemical Industries, Ltd., solid content of 47%), 50 parts of the polyether compound synthesized in Synthesis Example 1 (Synthesis Example 1b), 65.5 parts of Rionol Green 2YS (manufactured by Toyo Ink MFG. Co. , Ltd.) and 12.1 parts of Rionogen Yellow 3G (manufactured by Toyo Ink MFG. Co., Ltd.) as coloring matters, 4.04 parts of the dispersant, and 345.1 parts of methylpropylene glycol acetate were mixed, and the mixture was sufficiently dispersed by means of a sand mill to prepare a green paste. Subsequently, 526.8 parts of the green paste, 28.7 parts of NK Ester (manufactured by Shin-Nakamura Chemical Co., Ltd.), 1.32 part of Irgacure 907 (Irg 907: manufactured by Ciba-Geigy Ltd.), 1.32 part of Kayacure DETX (manufactured by Nippon Kayaku Co. , Ltd.), 0. 66 part of Kayacure EPA (manufactured by Nippon Kayaku Co., Ltd.), and 350.5 parts of methylpropylene glycol acetate were sufficiently mixed in a vessel capable of performing stirring to prepare a green resist with a non-volatile component content of about 20%.

### (Example 3: Preparation of a blue-colored resist)

100 parts of the commercially available product (ACA 200 manufactured by Daicel Chemical Industries, Ltd., solid content of 47%), 50 parts of the polyether compound synthesized in Synthesis Example 1 (Synthesis Example 1b), 41.9 parts of Rionol Blue ES (manufactured by Toyo Ink MFG. Co., Ltd.) and 10. 5 parts of Rionogen Violet RL (manufactured by Toyo Ink MFG. Co., Ltd.) as coloring matters, 2.96 parts of the dispersant, and 276.8 parts of methylpropylene glycol acetate were mixed, and the mixture was sufficiently dispersed by means of a sand mill to prepare a blue paste. Subsequently, 442.8 parts of the blue paste, 31.8 parts of NK Ester (manufactured by Shin-Nakamura Chemical Co., Ltd.), 1.63 part of Irgacure 907 (Irg 907: manufactured by Ciba-Geigy Ltd.), 1.63 part of Kayacure DETX (manufactured by Nippon Kayaku Co. , Ltd.), 0. 81 part of Kayacure EPA (manufactured by Nippon Kayaku Co., Ltd.), and 254 parts of methylpropylene glycol acetate were sufficiently mixed in a vessel capable of performing stirring to prepare a blue resist with a non-volatile component content of about 20%.

### (Examples 4 to 9)

The red resist obtained as described above was subjected to microfiltration with a pore size of 1 µm, and was then spin-coated by means of a spin coater onto a glass substrate on which a black matrix pattern had been already formed in such a manner that the thickness after the drying of the solvent would be 1.3 µm. Subsequently, the resultant was pre-baked at 60°C for 20 minutes. Then, an aqueous solution of polyvinyl alcohol was spin-coated onto the resultant, and then water was dried. After that, the resultant was subjected to exposure by using a photomask for forming a pattern. The resultant was developed with a 1% aqueous solution of sodium carbonate decahydrate, washed with pure water, and post-baked at 230°C for 1 hour. Green and blue patterns were similarly formed to prepare a color filter.

### (Examples 10 to 15, Comparative Examples 1 to 5)

Color filters were produced in the same manner as in Examples 4 to 9 except that the polyether compound, the monomer (DHPA), and the like were changed.

The color filters obtained in Examples and Comparative Examples were evaluated for performance according to the following method. Table 3 shows the results.

(Tackiness) A coating film obtained by application by means of a spin coater and drying was irradiated with ultraviolet rays at 40 mJ/cm² through a test chart (having a line width in the range of 0.5 to 50.0 µm). After that, the contamination of the test chart was visually observed. The results of evaluation were represented by ○: none, Δ: slightly observed, and ×: film contamination is remarkable.

(Resolution) A coating film obtained by application by means of a spin coater and drying was irradiated with ultraviolet rays at 40 mJ/cm² through a test chart (having a line width in the range of 0.5 to 50.0 µm). After that, the resultant was immersed in a 1% aqueous solution of sodium carbonate decahydrate for 60 seconds, and then resolution was measured. The table shows a numerical value (unit: µm) of a reading limit of the test chart.

(Transmittance) A coating film obtained in the same manner as in the resolution measurement was heated for 60 minutes in a warm air circulating-type drier at 230°C. The transmittance of the resultant cured coating film was measured by means of a spectrophotometer (manufactured by Nippon Kogaku Corporation) with light having a wavelength of 700 nm for a red-colored resist, light having a wavelength of 540 nm for a green resist, and light having a wavelength of 460 nm for a blue-colored resist.

(Heat resistance) A cured coating film obtained in the same manner as in the transmittance measurement was heated for 60 minutes in a hot air convection-type drying furnace at 250°C. After that, a change in transmittance at a predetermined wavelength before and after the heating was measured. The results of evaluation were represented by ○: 5% or less, Δ: 5 to 10%, and ×: 10% or more.

(Chemical resistance) A film was immersed at 25°C for 30minutes in each of (a) isopropyl alcohol, (b) cyclohexanone, (c) diglyme, (d) acetone, (e) butyl acetate, and (f) a 5% aqueous solution of NaOH. After that, the presence or absence of an interface at an immersed portion was visually observed. The results of evaluation were represented by ○: none, Δ: slightly observed, and ×: film reduction is remarkable.

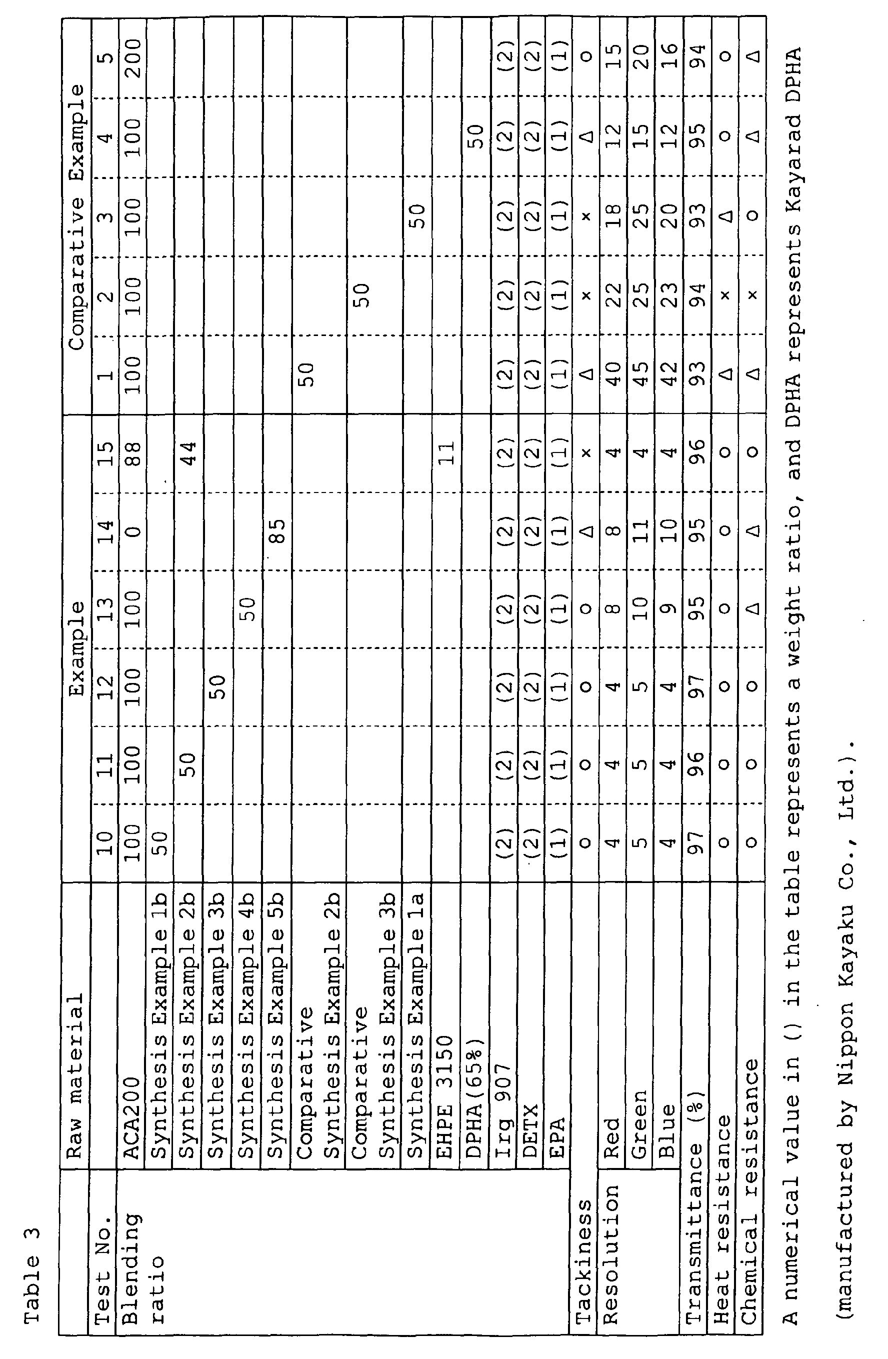

### INDUSTRIAL APPLICABILITY

According to the present invention, there can be provided a colored photosensitive composition for a color filter which has no tackiness even after the removal of a solvent, which does not contaminate a photomask at the stage of exposure, and which has sufficient photosensitivity and sufficient resolution.

## Claims

1. A colored photosensitive composition for a color filter, **characterized by** comprising:
a polyether compound represented by the following formula (4) having multiple polymerizable unsaturated groups and one or more acid groups in one molecule;
a coloring matter; and
a curable resin and/or an ethylenically unsaturated compound to be optionally added, 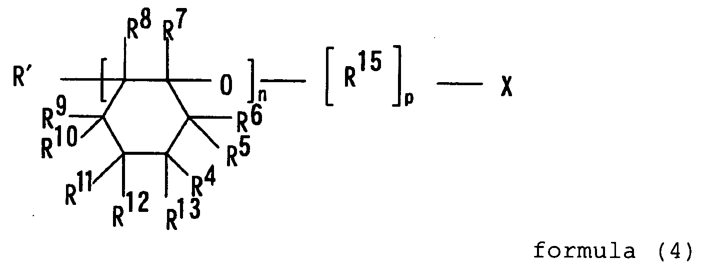 [In the formula (4): R' represents a residue -RHₘ₋₁ of an organic compound RHₘ containing "m" pieces of active hydrogen atoms in one molecule, or a group derived from the residue; R represents a residue obtained by removing an active hydrogen atom from an organic compound having the active hydrogen atom; "m" represents an integer of 1 to 30; R⁴ to R¹³ each represent a hydrogen atom, a hydrocarbon group having 1 to 10 carbon atoms, or a hydrocarbon group having 1 to 10 carbon atoms and an unsaturated group, provided that the unsaturated group contains -OCO-CR³=CR¹R², R¹ and R² each represent a hydrogen atom, R³ represents a hydrogen atom or a hydrocarbon group having 1 to 10 carbon atoms, and at least one of R⁴ to R¹³ represents a hydrocarbon group having 1 to 10 carbon atoms and the unsaturated group; R¹⁵ represents a residue of a polybasic acid anhydride; X represents -COOH, -OPO(OH)ₐ(OR)_{b}, or -OSO₃R (provided that R represents a hydrogen atom, a methyl group, or an ethyl group, "a" represents 1 or 0, and "a+b" = 2); "n" represents an integer of 1 or more, and the number of structural units in the entire molecule represented by n is in a range of 2 to 50; and "p" represents 0 when X represents -OPO(OH)ₐ(OR)_{b} or -OSO₃R, while "p" represents an integer of 1 or more when X represents -COOH].

2. A colored photosensitive composition for a color filter according to claim 1, wherein the polyether compound comprises one represented by the following formula (4A) having multiple (meth) acryloyl groups and one or more carboxyl groups in one molecule. 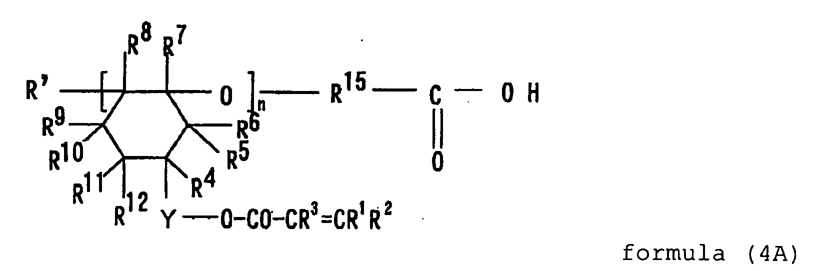 [In the formula (4A), R' represents a residue -RHₘ₋₁ of an organic compound RHₘ containing m or more active hydrogen atoms in one molecule, or a group derived from the residue; R represents a residue obtained by removing an active hydrogen atom from an organic compound having the active hydrogen atom; "m" represents an integer of 1 to 30; R⁴ to R¹² each represent a hydrogen atom or a hydrocarbon group having 1 to 10 carbon atoms; R¹ and R² of -OCO-CR³=CR¹R² each represent a hydrogen atom, and R³ of -OCO-CR³=CR¹R² represents a hydrogen atom or a methyl group; Y represents -(CH₂)ₙ₁- where n1 represents an integer of 1 to 6, one obtained by substituting part of the hydrogen atoms constituting - (CH₂)ₙ₁- by methyl groups, ethyl groups, or propyl groups, or one of the following structural formulae 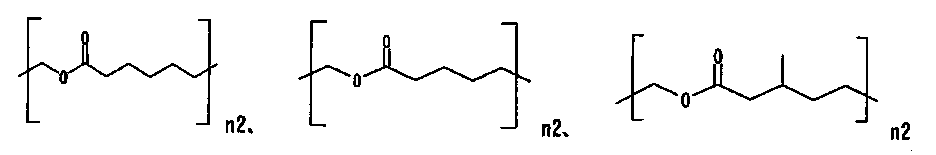 where n2 represents an integer of 1 to 10; R¹⁵ represents a residue produced by ring-opening of a polybasic acid anhydride; and "n" represents an integer of 1 or more, and the number of structural units in the entire molecule represented by "n" is in a range of 2 to 50].

3. A colored photosensitive composition for a color filter according to claim 1 or 2, wherein the polybasic acid anhydride comprises at least one selected from the group consisting of tetrahydrophthalic anhydride, 4-methyltetrahydrophthalic anhydride, 3-methyltetrahydrophthalic anhydride, 3,4,5,6-tetrahydrophthalic anhydride, hexahydrophthalic anhydride, and 4-methyltetrahydrophthalic anhydride.

4. A colored photosensitive composition for a color filter according to claim 1, wherein the polyether compound comprises a polyether compound represented by the following formula (4A') obtained by reacting a compound represented by the following formula (3A) with a polybasic acid anhydride, the compound represented by the following formula (3A) being obtained by reacting an organic compound RHₘ containing "m" pieces of active hydrogen atoms in one molecule which is at least one selected from the group consisting of carboxylic acids, alcohols, phenols, amines, thiols, and silanols, and in which "m" represents an integer of 1 to 30 (hereinafter, they are represented by R*Hₘ) with a compound represented by the following formula (2A), 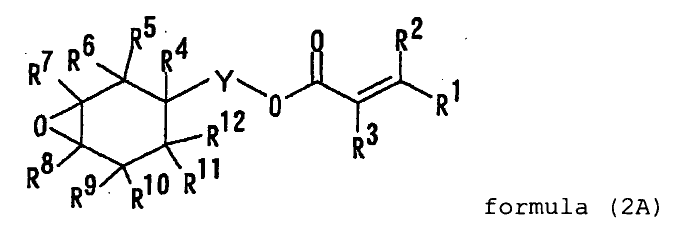 <In the formula (2A) : R¹ and R² each represent a hydrogen atom; R³ represents a hydrogen atom or a methyl group; R⁴ to R¹² each represent a hydrogen atom, a methyl group, an ethyl group, or a propyl group; and Y represents -(CH₂)ₙ₁- where n1 represents an integer of 1 to 6, one obtained by substituting part of the hydrogen atoms constituting -(CH₂)ₙ₁- by methyl groups, ethyl groups, or propyl groups, or one of the following structural formulae 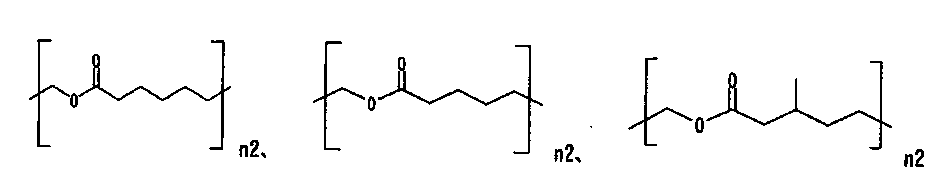 where n2 represents an integer of 1 to 10>, 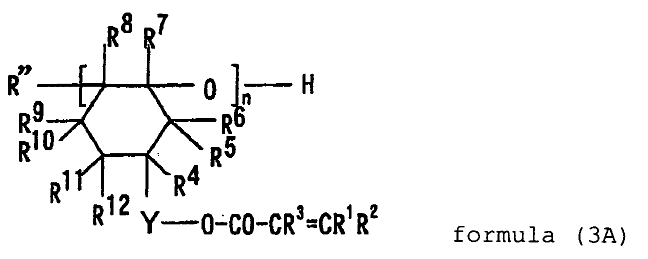 <In the formula (3A), R'' represents a residue -R*Hₘ₋₁ of carboxylic acids, alcohols, phenols, amines, thiols, or silanols, or a group derived from the residue; R¹ and R² each represent a hydrogen atom; R³ represents a hydrogen atom or a methyl group; R⁴ to R¹² each represent a hydrogen atom, a methyl group, an ethyl group, or a propyl group; Y is the same as that of the formula (2A); and "n" represents an integer of 2 to 50>, 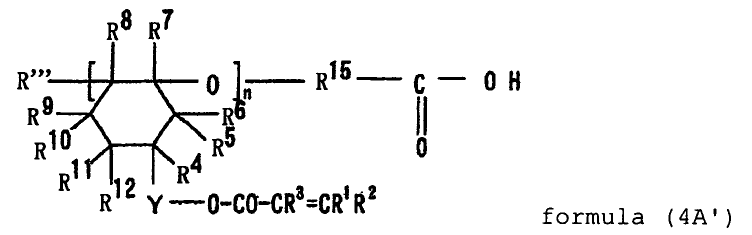 <In the formula (4A'), R¹⁵ represents a residue of a polybasic acid anhydride; and R''' represents a residue -R*Hₘ₋₁ or a group derived from the residue>.

5. A colored photosensitive composition for a color filter according to any one of claims 1 to 4, wherein the organic compound containing "m" pieces of active hydrogen atoms in one molecule comprises trimethylolpropane.

6. A colored photosensitive composition for a color filter according to claim 4 or 5, wherein the compound represented by the formula (2A) comprises 3,4-epoxycyclohexylmethyl (meth)acrylate.

7. A colored photosensitive composition for a color filter according to claim 1, wherein the curable resin comprises a resin obtained by reacting a (meth) acrylic acid- (meth) acrylate copolymer with a compound represented by the formula (2A), 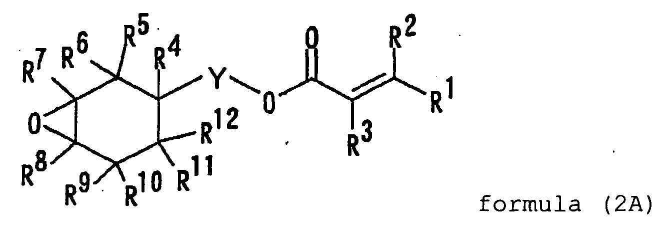 <In the formula (2A), R¹ and R² each represent a hydrogen atom; R³ represents a hydrogen atom or a methyl group; R⁴ to R¹² each represent a hydrogen atom, a methyl group, an ethyl group, or a propyl group; and Y represents -(CH₂)ₙ₁- where n1 represents an integer of 1 to 6, one obtained by substituting part of the hydrogen atoms constituting -(CH₂)ₙ₁- by methyl groups, ethyl groups, or propyl groups, or one of the following structural formulae 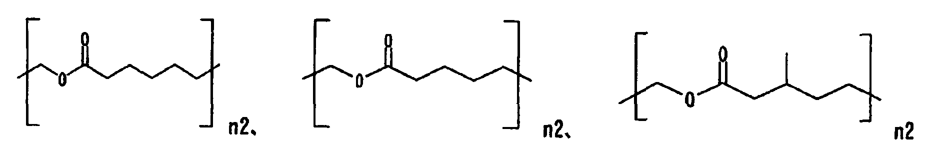 where n2 represents an integer of 1 to 10>.

8. A colored photosensitive composition for a color filter according to claim 1, wherein the polyether compound comprises a polyether compound represented by the formula (4) obtained by reacting a compound represented by the following formula (3) with any one of a polybasic acid anhydride, phosphoric acid, ethyl phosphate, diethyl phosphate, a monoalkyl ester or dialkyl ester of glucose phosphate, sulfuric acid, methyl sulfate, and ethyl sulfate, the compound represented by the following formula (3) being obtained by reacting an organic compound RHₘ containing "m" pieces of active hydrogen atoms in one molecule (provided that "m" represents an integer of 1 to 30, and R represents a residue obtained by removing an active hydrogen atom from an organic compound having the active hydrogen atom) with a compound represented by the following formula (2), 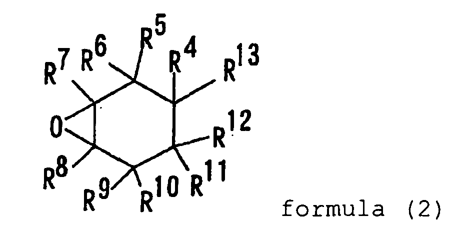 <R⁴ to R¹³ each represent a hydrogen atom, a hydrocarbon group having 1 to 10 carbon atoms, or a hydrocarbon group having 1 to 10 carbon atoms and an unsaturated group, provided that the unsaturated group contains -OCO-CR³=CR¹R², at least one of R⁴ to R¹³ represents the unsaturated group, R¹ and R² each represent a hydrogen atom, and R³ represents a hydrogen atom or a hydrocarbon group having 1 to 10 carbon atoms>, 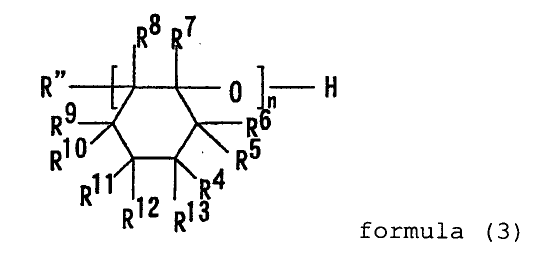 <In the formula (3), R'' represents a residue -RHₘ₋₁ of an organic compound containing "m" pieces of active hydrogen atoms in one molecule, or a group derived from the residue; R represents a residue obtained by removing an active hydrogen atom from an organic compound having the active hydrogen atom; and R⁴ to R¹³ each represent a hydrogen atom, a hydrocarbon group having 1 to 10 carbon atoms, or a hydrocarbon group having 1 to 10 carbon atoms and an unsaturated group, provided that the unsaturated group contains -OCO-CR³=CR¹R², R¹ and R² each represent a hydrogen atom, and R³ represents a hydrogen atom or a hydrocarbon group having 1 to 10 carbon atoms>, 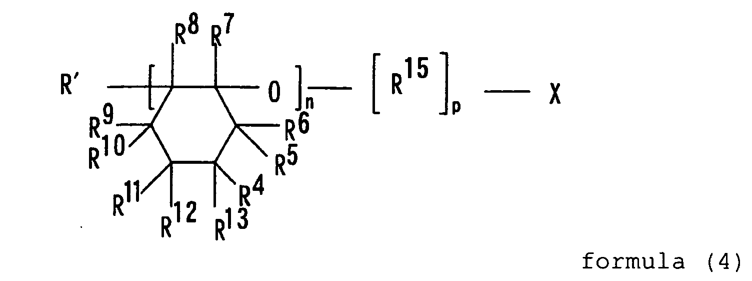 [In the formula (4), R' represents a residue -RHₘ₋₁ of an organic compound RHₘ containing "m" pieces of active hydrogen atoms in one molecule, or a group derived from the residue; R represents a residue obtained by removing an active hydrogen atom from an organic compound having the active hydrogen atom; "m" represents an integer of 1 to 30; R⁴ to R¹³ each represent a hydrogen atom, a hydrocarbon group having 1 to 10 carbon atoms, or a hydrocarbon group having 1 to 10 carbon atoms and an unsaturated group, provided that the unsaturated group contains -OCO-CR³=CR¹R², R¹ and R² each represent a hydrogen atom, R³ represents a hydrogen atom or a hydrocarbon group having 1 to 10 carbon atoms, and at least one of R⁴ to R¹³ represents a hydrocarbon group having 1 to 10 carbon atoms and the unsaturated group; R¹⁵ represents a residue of a polybasic acid anhydride; X represents -COOH, -OPO(OH)ₐ(OR)_{b}, or -OSO₃R [provided that R represents a hydrogen atom, a methyl group, or an ethyl group, "a" represents 1 or 0, and "a+b" = 2]; "n" represents an integer of 1 or more, and the number of structural units in the entire molecule represented by "n" is in a range of 2 to 50; and "p" represents 0 when X represents -OPO(OH)ₐ(OR)_{b} or -OSO₃R, while "p" represents an integer of 1 or more when X represents -COOH].

9. A colored photosensitive composition for a color filter according to claim 1, wherein the curable resin and/or the ethylenically unsaturated compound to be optionally added comprise an epoxy group-containing resin and/or an acid group-containing resin.

10. A colored photosensitive composition for a color filter according to any one of claims 1 to 9, wherein the polyether compound comprises a polyether compound synthesized by using a reactive diluent as a solvent.

11. A colored photosensitive composition for a color filter according to any one of claims 1 to 9, wherein the polyether compound comprises a polyether compound synthesized by passing a mixed gas containing oxygen through a reaction system.

12. A color filter obtained by: applying the colored photosensitive composition for a color filter according to any one of claims 1 to 11; and curing the applied composition.

13. A method of producing a color filter, **characterized by** comprising the steps of:
applying the colored photosensitive composition according to any one of claims 1 to 11 onto a substrate;
subjecting the colored photosensitive composition applied onto the substrate to pattern exposure to photo-cure the colored photosensitive composition in an exposed portion; and
developing the colored photosensitive composition subjected to the pattern exposure to leave a pattern-like colored layer obtained by photo-curing the colored photosensitive composition on the substrate.
